# EUROPEAN PATENT APPLICATION

(11) **EP 4 770 357 A1**
(43) Date of publication of application: **01.07.2026**
(21) Application number: 25224531.1
(22) Date of filing: 17.12.2025
(51) Int. Cl.: H10H 29/24, H10H 29/80, H10H 29/85

(54) **DISPLAY APPARATUS INCLUDING LIGHT-EMITTING DEVICE AND METHOD OF MANUFACTURING THE SAME**

(30) Priority: 26.12.2024 KR 20240197375
(71) Applicant: Samsung Electronics Co., Ltd., Suwon-si, Gyeonggi-do 16677 (KR)
(72) Inventor: OH, Youngtek, 16677 Suwon-si (KR); KIM, Joosung, 16678 Suwon-si (KR); SHIN, Dongchul, 16677 Suwon-si (KR); HWANG, Kyungwook, 16677 Suwon-si (KR)
(74) Representative: Arnold & Siedsma

(57) **Abstract**

Display apparatus including light-emitting device and method of manufacturing the same. Provided is a display apparatus including a display layer comprising a plurality of light-emitting devices, and a driving layer configured to drive the light-emitting devices, at least one of the light-emitting devices including a light-emitting structure including a first light-emitting element, a second light-emitting element, and a third light-emitting element are on the driving layer, a first electrode pattern, and a second electrode pattern, the first to third light-emitting elements being configured to emit light of different wavelengths and each including a first-type semiconductor layer, an active layer, and a second-type semiconductor layer, the first electrode pattern being configured to apply independent voltages respectively to the second-type semiconductor layers of the light-emitting structure, and the second electrode pattern being configured to apply a common voltage to the first-type semiconductor layers of the light-emitting structure.

## Description

### FIELD

Embodiments of the present disclosure to a light-emitting device, a display apparatus including the light-emitting device, and a method of manufacturing the display apparatus.

### BACKGROUND

Light-emitting devices such as light-emitting diodes (LEDs) are known as the next generation of light sources owing to advantages over light sources of the related art, such as a longer lifespan, lower power consumption, faster response time, and environmental friendliness. Owing to these advantages, industrial demand for such light-emitting devices has increased. LEDs are commonly applied to various products such as lighting devices and display apparatuses.

Recently, ultra-small light-emitting diodes (LEDs) having microscale or nanoscale dimensions have been developed, and these are referred to as micro LEDs. Micro LEDs are applied to relatively large display apparatuses such as televisions, and further attempts are being made to apply micro LEDs to small display apparatuses, such as displays for augmented reality (AR) devices. Micro LEDs applied to relatively small display apparatuses are extremely small, measuring only a few micrometers in size, making it difficult to secure a relatively large light-emitting area. For example, in micro LEDs in which RGB sub-pixels are vertically arranged, the light-emitting area is reduced due to electrodes used to drive each sub-pixel, which may lead to a decrease in the light emission efficiency of the micro LED.

### SUMMARY

One or more embodiments provide a monolithic light-emitting device having an epitaxial structure in which a plurality of light-emitting elements emitting light of different wavelengths are vertically stacked, a display apparatus including the light-emitting device, and a method of manufacturing the display apparatus.

One or more embodiments also provide a light-emitting device with improved light emission efficiency, a display apparatus including the light-emitting device, and a method of manufacturing the display apparatus.

Additional aspects will be set forth in part in the description which follows and, in part, will be apparent from the description, or may be learned by practice of one or more embodiments.

According to an aspect of one or more embodiments, there is provided a display apparatus including a display layer including a plurality of light-emitting devices, and a driving layer configured to drive the plurality of light-emitting devices, wherein at least one of the plurality of light-emitting devices includes a light-emitting structure including a first light-emitting element, a second light-emitting element, and a third light-emitting element are on the driving layer, the first light-emitting element, the second light-emitting element, and the third light-emitting element being configured to emit light of different wavelengths and each of the first light-emitting element, the second light-emitting element, and the third light-emitting element including a first-type semiconductor layer, an active layer, and a second-type semiconductor layer, a first electrode pattern on a first outer surface of the light-emitting structure and a lower surface of the light-emitting structure, the first electrode pattern being configured to apply independent voltages respectively to the second-type semiconductor layers of the light-emitting structure, a second electrode pattern on a second outer surface of the light-emitting structure and the lower surface of the light-emitting structure, the second electrode pattern being configured to apply a common voltage to the first-type semiconductor layers of the light-emitting structure, and an insulating layer between the first electrode pattern and the light-emitting structure and between the second electrode pattern and the light-emitting structure, the insulating layer including a plurality of openings, the first electrode pattern and the second electrode pattern being connected to the light-emitting structure through the plurality of openings, wherein the first outer surface includes convex portions at which the second-type semiconductor layers of the light-emitting structure protrude from the first-type semiconductor layers and the active layers that are respectively adjacent to the second-type semiconductor layers. In the context of the present disclosure, the convex portions can also be denoted as protruded portions.

The first-type semiconductor layers may be n-type semiconductor layers, and the second-type semiconductor layers may be p-type semiconductor layers.

The first electrode pattern may include a first electrode connected to the second-type semiconductor layer of the first light-emitting element through a first opening of the insulating layer, a second electrode connected to the second-type semiconductor layer of the second light-emitting element through a second opening of the insulating layer, and a third electrode connected to the second-type semiconductor layer of the third light-emitting element through a third opening of the insulating layer, wherein the first electrode, the second electrode, and the third electrode may be spaced apart from each other.

At least one of the first opening, the second opening, and the third opening may be on the convex portions.

The second outer surface may include a concave portion at which at least one of the first-type semiconductor layers of the light-emitting structure is recessed into the light-emitting structure. In the context of the present disclosure, the concave portions can also be denoted as recessed portions.

The second electrode pattern may contact at least one of the first-type semiconductor layers of the light-emitting structure at the concave portion.

The second electrode pattern may contact an outer surface of at least one of the first-type semiconductor layers at the concave portion.

The second electrode pattern may contact a lower surface of at least one of the first-type semiconductor layers at the concave portion.

The second electrode pattern may contact the first-type semiconductor layer of the first light-emitting element through a fourth opening of the insulating layer, the first-type semiconductor layer of the second light-emitting element through a fifth opening of the insulating layer, and the first-type semiconductor layer of the third light-emitting element through a sixth opening of the insulating layer.

At least one of the fourth opening, the fifth opening, and the sixth opening may be on the concave portion.

The fourth opening may be on a lower surface of the first-type semiconductor layer of the first light-emitting element.

In each of the first light-emitting element, the second light-emitting element, and the third light-emitting element, the first-type semiconductor layer, the active layer, and the second-type semiconductor layer may be stacked sequentially from the driving layer.

A width of the light-emitting structure in a horizontal direction may gradually increase in a vertical direction from the first light-emitting element toward the third light-emitting element.

A first wavelength of light emitted by the first light-emitting element may be less than a second wavelength of light emitted by the second light-emitting element, and the second wavelength of light may be less than a third wavelength of light emitted by the third light-emitting element.

A width of each of the second-type semiconductor layers of the light-emitting structure in a horizontal direction may gradually increase in a vertical direction away from the driving layer.

The display apparatus may further include an optical layer on the display layer and configured to control a propagation path of light emitted from the display layer.

The optical layer may include a plurality of microlenses corresponding one-to-one to the plurality of light-emitting devices.

The display layer may further include a scattering pattern that is configured to scatter light emitted from the display layer;

According to another aspect of one or more embodiments, there is provided a method of manufacturing a display apparatus, the method including forming a light-emitting structure by sequentially monolithically stacking a first light-emitting element, a second light-emitting element, and a third light-emitting element on a growth substrate, the first light-emitting element, the second light-emitting element, and the third light-emitting element being configured to emit light of different wavelengths and each of the first light-emitting element, the second light-emitting element, and the third light-emitting element including a first-type semiconductor layer, an active layer, and a second-type semiconductor layer, forming protrusions on a first outer surface of the light-emitting structure, the second-type semiconductor layers of the light-emitting structure protruding outward at the protrusions from the first-type semiconductor layers and the active layers that are respectively adjacent to the second-type semiconductor layers, forming concave portions on a second outer surface of the light-emitting structure and recessed respectively into the first-type semiconductor layers of the light-emitting structure, forming a first electrode pattern and a second electrode pattern, the first electrode pattern being in contact with the second-type semiconductor layers through the protrusions, the second electrode pattern contacting the first-type semiconductor layers through the concave portions, and bonding the first electrode pattern and the second electrode pattern to a backplane.

According to still another aspect of one or more embodiments, there is provided an electronic apparatus including a display panel including a display layer including a plurality of light-emitting devices, and a driving layer configured to drive the plurality of light-emitting devices, and at least one processor configured to control the display panel based on an image signal, wherein at least one of the plurality of light-emitting devices includes a light-emitting structure including a first light-emitting element, a second light-emitting element, and a third light-emitting element are on the driving layer, the first light-emitting element, the second light-emitting element, and the third light-emitting element being configured to emit light of different wavelengths and each of the first light-emitting element, the second light-emitting element, and the third light-emitting element including a first-type semiconductor layer, an active layer, and a second-type semiconductor layer, a first electrode pattern on a first outer surface of the light-emitting structure and a lower surface of the light-emitting structure, the first electrode pattern being configured to apply independent voltages respectively to the second-type semiconductor layers of the light-emitting structure, a second electrode pattern on a second outer surface of the light-emitting structure and the lower surface of the light-emitting structure, the second electrode pattern being configured to apply a common voltage to the first-type semiconductor layers of the light-emitting structure, and an insulating layer between the first electrode pattern and the light-emitting structure and between the second electrode pattern and the light-emitting structure, the insulating layer including a plurality of openings, the first electrode pattern and the second electrode pattern being connected to the light-emitting structure through the plurality of openings.

All features and embodiment described in relation to the display apparatus can also be applied and combined with the electronic apparatus.

### BRIEF DESCRIPTION OF DRAWINGS

The above and other aspects, features, and advantages of embodiments will be more apparent from the following description taken in conjunction with the accompanying drawings, in which:
FIG. 1A is a cross-sectional view illustrating a light-emitting device according to one or more embodiments;
FIG. 1B is another cross-sectional view illustrating the light-emitting device of FIG. 1A;
FIG. 1C is a view illustrating a lower surface of the light-emitting device of FIG. 1A;
FIG. 2 is a block diagram illustrating a display apparatus including a light-emitting device, according to one or more embodiments;
FIG. 3A is a cross-sectional view illustrating a portion of a display apparatus including a light-emitting device viewed from one perspective, according to one or more embodiments;
FIG. 3B is another cross-sectional view illustrating the display apparatus of FIG. 3A;
FIG. 4 is a view illustrating a display apparatus including an optical layer that controls an optical path, according to one or more embodiments;
FIG. 5 is a view illustrating a display apparatus including a scattering pattern, according to one or more embodiments;

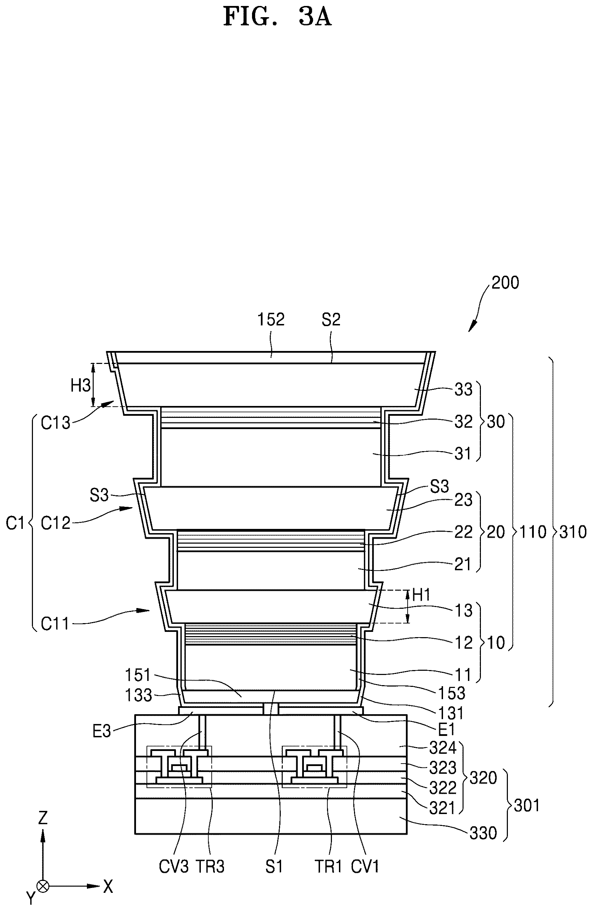

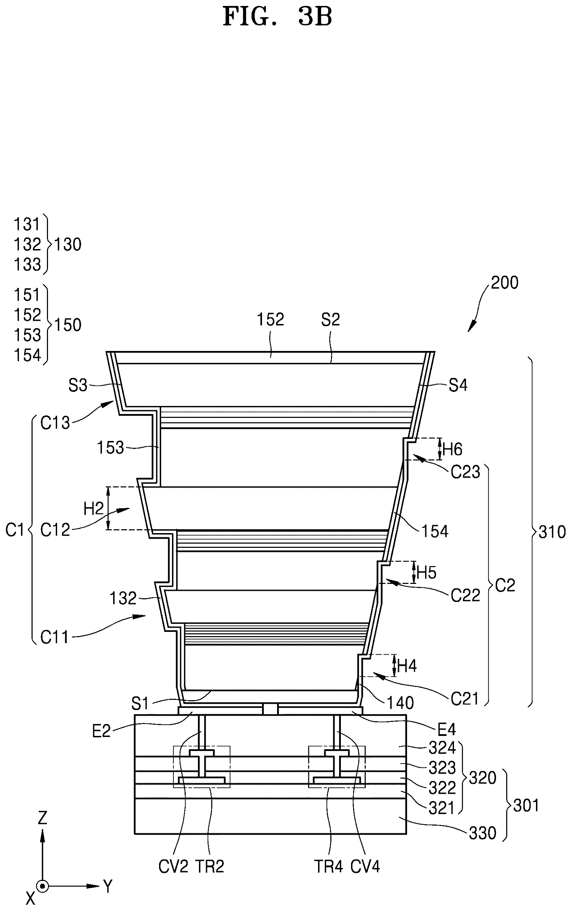

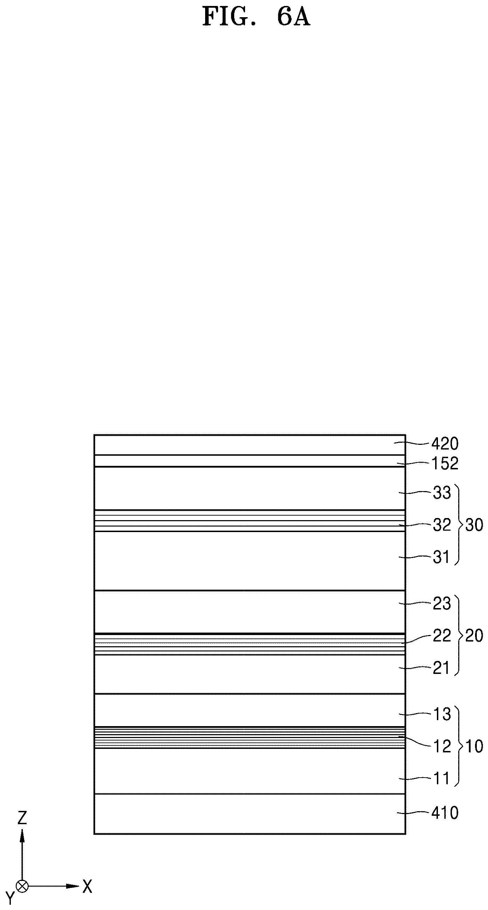

FIGS. 6A, 6B, 7A, 7B, 8A, 8B, 9A, 9B, 10A, 10B, 11A, 11B, 12A, 12B, 13A, 13B, 14A, and 14B are cross-sectional views sequentially illustrating operations in a method of manufacturing a display apparatus, according to embodiments, in which FIGS. 6A, 7A, 8A, 9A, 10A, 11A, 12A, 13A, and 14A are reference views illustrating the manufacturing method in relation to the cross-sectional view of the display apparatus shown in FIG. 3A, and FIGS. 6B, 7B, 8B, 9B, 10B, 11B, 12B, 13B, and 14B are reference views illustrating the manufacturing method in relation to the cross-sectional view of the display apparatus shown in FIG. 3B;
FIG. 15 is a view illustrating a display apparatus according to one or more other embodiments;
FIG. 16 is a view illustrating a display apparatus according to one or more other embodiments;
FIG. 17A is a cross-sectional view illustrating a display apparatus viewed from a first perspective, according to one or more other embodiments;
FIG. 17B is a cross-sectional view illustrating the display apparatus of FIG. 17A viewed from another perspective;
FIG. 17C is a view illustrating a lower surface of the light-emitting device included in the display apparatus of FIG. 17A;

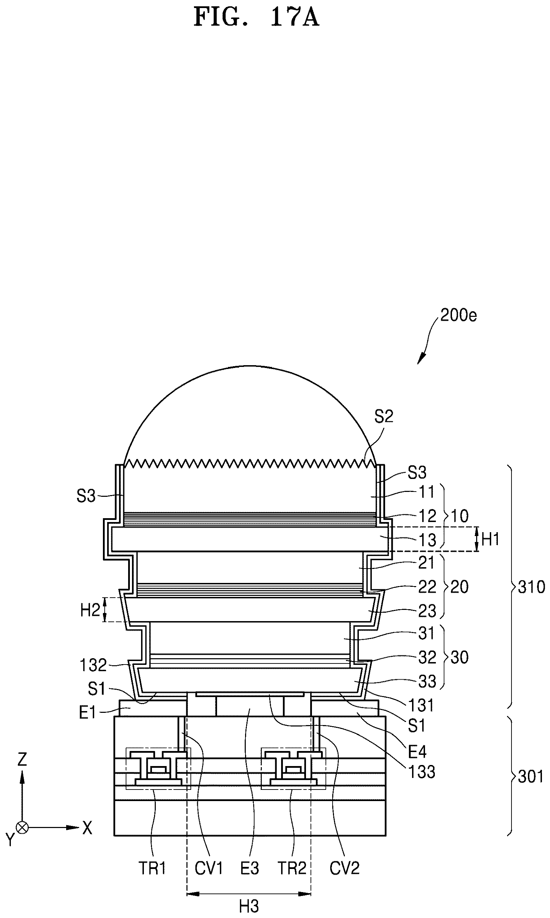

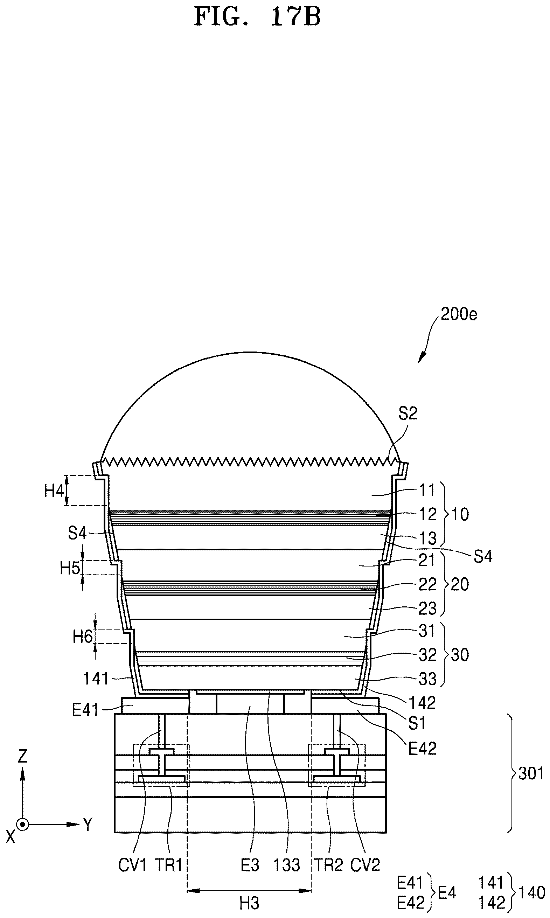

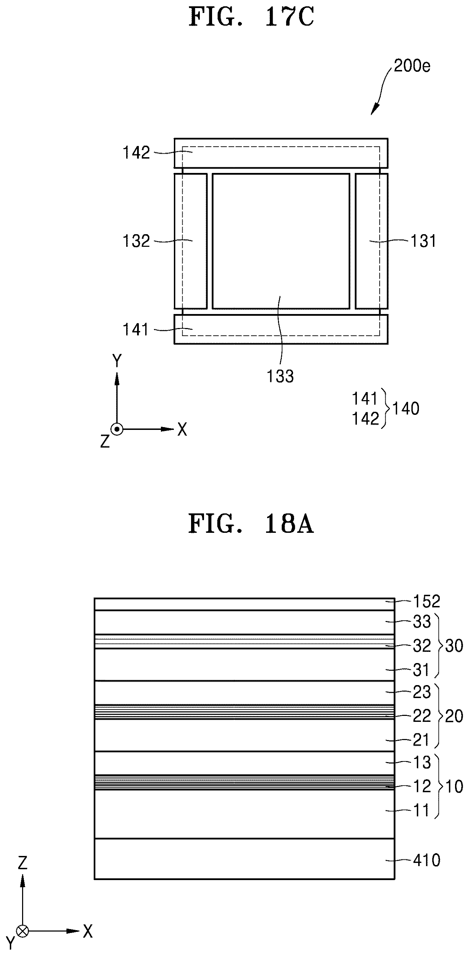

FIGS. 18A, 18B, 19A, 19B, 20A, 20B, 21A, 21B, 22A, 22B, 23A , 23B, 24A, and 24B are cross-sectional views sequentially illustrating operations in a method of manufacturing the display apparatus, according to embodiments, in which FIGS. 18A, 19A, 20A, 21A, 22A, 23A, and 24A are reference views illustrating the manufacturing method in relation to the cross-sectional view of the display apparatus shown in FIG. 17A, and FIGS. 18B, 19B, 20B, 21B, 22B, 23B, and 24B are reference views illustrating the manufacturing method in relation to the cross-sectional view of the display apparatus shown in FIG. 17B;
FIGS. 25A and 25B are views illustrating a display apparatus according to one or more other embodiments;
FIG. 26 is a view schematically illustrating an electronic apparatus including a display apparatus according to one or more embodiments;
FIG. 27 is a view illustrating an example in which a display apparatus is applied to a mobile apparatus according to one or more embodiments;
FIG. 28 is a view illustrating an example in which a display apparatus is applied to an vehicle according to one or more embodiments;
FIG. 29 is a view illustrating an example in which a display apparatus is applied to augmented reality (AR) glasses or virtual reality (VR) glasses according to one or more embodiments;
FIG. 30 is a view illustrating an example in which a display apparatus is applied to large signage according to one or more embodiments; and
FIG. 31 is a view illustrating an example in which a display apparatus is applied to a display of a wearable apparatus according to one or more embodiments.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

Hereinafter, embodiments will be described with reference to the accompanying drawings. The embodiments described herein are for illustrative purposes only, and various modifications may be made therein. In the drawings, like reference numerals refer to like elements, and the sizes of elements may be exaggerated for clarity of illustration.

In the following description, when an element is referred to as being "above" or "on" another element, it may be directly on the other element while making contact with the other element or may be above the other element without making contact with the other element.

Although the terms "first" and "second" are used to describe various elements, these terms are only used to distinguish one element from another element. These terms do not limit elements to having different materials or structures.

The terms of a singular form may include plural forms unless otherwise mentioned. It will be further understood that the terms "comprises" and/or "comprising" used herein specify the presence of stated features or elements, but do not preclude the presence or addition of one or more other features or elements.

In the present disclosure, terms such as "unit" or "module" may be used to denote a unit that has at least one function or operation and is implemented with hardware, software, or a combination of hardware and software.

Specific executions described herein are merely examples and do not limit the scope of the present disclosure in any way. For simplicity of description, other functional aspects of conventional electronic configurations, control systems, software and the systems may be omitted. Furthermore, line connections or connection members between elements depicted in the drawings represent functional connections and/or physical or circuit connections by way of example, and in actual applications, they may be replaced or embodied as various additional functional connections, physical connections, or circuit connections.

An element referred to with the definite article or a demonstrative pronoun may be construed as the element or the elements even though it has a singular form.

Operations of a method may be performed in appropriate order unless explicitly described in terms of order or described to the contrary. In addition, examples or terms (for example, "such as" and "etc.") are used for the purpose of description and are not intended to limit the scope of the inventive concept unless defined by the claims.

The disclosure provides a light-emitting device, such as a vertical RGB micro light-emitting diode (LED), having improved light emission efficiency by securing a sufficient light-emitting area without conductive vias. The disclosure also provides a display apparatus incorporating the light-emitting device.

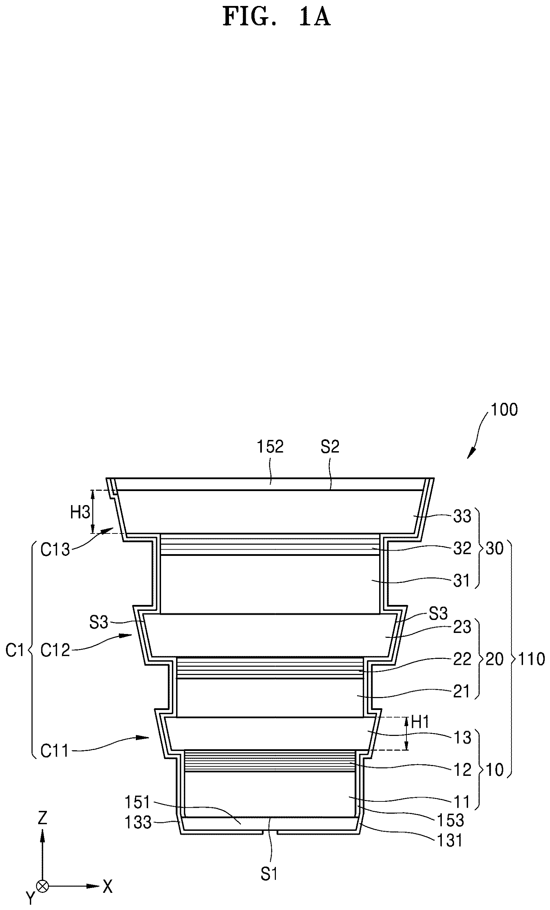

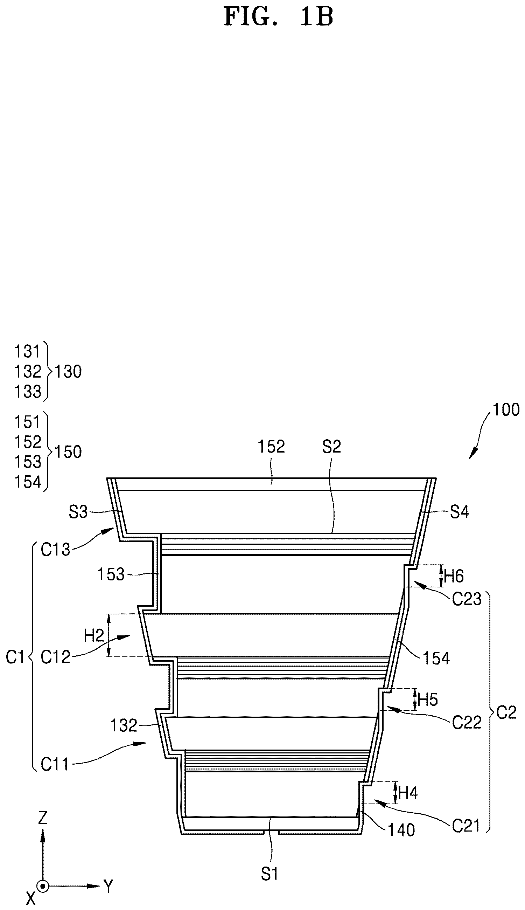

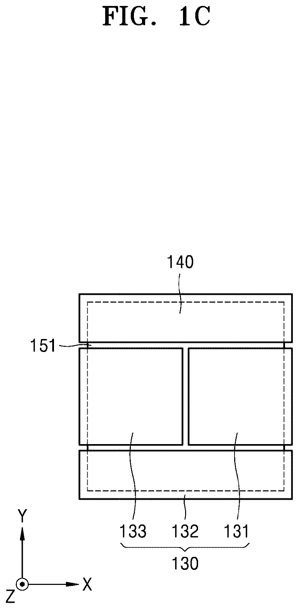

FIG. 1A is a cross-sectional view illustrating a light-emitting device 100, according to one or more embodiments. FIG. 1B is another cross-sectional view illustrating the light-emitting device 100 of FIG. 1A. FIG. 1C is a bottom view illustrating the light-emitting device 100 shown in FIG. 1A.

Referring to FIGS. 1A to 1C, according to one or more embodiments, the light-emitting device 100 may include an organic-based LED and may emit light of a specific wavelength depending on a material included in the light-emitting device 100. According to one or more embodiments, the light-emitting device 100 may have a micro size. For example, a width W of the light-emitting device 100 in a horizontal direction (X direction and/or Y direction) may be about 50 µm or less, about 10 µm or less, about 5 µm or less, or about 3 µm or less. Here, the width W of the light-emitting device 100 may refer to the maximum width of the light-emitting device 100 in the horizontal direction (X direction and/or Y direction).

According to one or more embodiments, the light-emitting device 100 may include a light-emitting structure 110 in which a plurality of light-emitting elements are configured to emit light of different wavelengths are monolithically stacked. A transversal cross-section of the light-emitting structure 110 parallel to the horizontal direction (X direction and/or Y direction) of the light-emitting structure 110 may be polygonal, circular, or the like. For example, the transversal cross-section of the light-emitting structure 110 may be tetragonal. As another example, the transversal cross-section of the light-emitting structure 110 may be tetragonal with a fine concavo-convex pattern. A longitudinal cross-section of the light-emitting structure 110 parallel to a vertical direction (a thickness direction, for example, a direction Z) of the light-emitting structure 110 may be tetragonal. For example, the longitudinal cross-section of the light-emitting structure 110 may be trapezoidal.

The light-emitting structure 110 may have a structure in which a first light-emitting element 10 is configured for emitting light of a first wavelength, a second light-emitting element 20 is configured for emitting light of a second wavelength that is different from the first wavelength, and a third light-emitting element 30 is configured for emitting light of a third wavelength that is different from the first and second wavelengths are stacked in the thickness direction (for example, the direction Z) of the light-emitting structure 110. For example, the first light-emitting element 10 may emit blue light, the second light-emitting element 20 may emit green light, and the third light-emitting element 30 may emit red light. As described below, the light-emitting structure 110 may be formed by sequentially and monolithically growing the first light-emitting element 10, the second light-emitting element 20, and the third light-emitting element 30 on a single growth substrate 410. Thus, the light-emitting structure 110 may not include a bonding material for coupling the light-emitting elements to each other.

The first light-emitting element 10 may include a first-type semiconductor layer 11, an active layer 12 provided on the first-type semiconductor layer 11, and a second-type semiconductor layer 13 provided on the active layer 12 opposite to the first-type semiconductor layer 11. The first-type semiconductor layer 11, the active layer 12, and the second-type semiconductor layer 13 may form a vertically stacked structure.

The first-type semiconductor layer 11 and the second-type semiconductor layer 13 may include a Group II-VI or Group III-V compound semiconductor material such as a nitride semiconductor material. For example, the first-type semiconductor layer 11 and the second-type semiconductor layer 13 may include at least one nitride semiconductor material from indium aluminum gallium nitride (InAlGaN), gallium nitride (GaN), aluminum gallium nitride (AlGaN), indium gallium nitride (InGaN), aluminum nitride (AlN), and indium nitride (InN). The first-type semiconductor layer 11 and the second-type semiconductor layer 13 may provide electrons and holes to the active layer 12. To this end, the first-type semiconductor layer 11 may be doped with an n-type dopant, and the second-type semiconductor layer 13 may be doped with a p-type dopant. For example, the first-type semiconductor layer 11 may include silicon (Si), germanium (Ge), tin (Sn), or the like as a dopant, and the second-type semiconductor layer 13 may include magnesium (Mg), zinc (Zn), or the like as a dopant. The first-type semiconductor layer 11 may supply electrons to the active layer 12, and the second-type semiconductor layer 13 may supply holes to the active layer 12.

The active layer 12 may be provided between the first-type semiconductor layer 11 and the second-type semiconductor layer 13. The active layer 12 has a quantum well structure in which a quantum well is provided between barriers. Light may be generated as electrons and holes provided from the first-type semiconductor layer 11 and the second-type semiconductor layer 13 recombine with each other within the quantum well of the active layer 12. The wavelength of light generated in the active layer 12 may be determined by the energy bandgap of a material forming the quantum well of the active layer 12. The active layer 12 may have a single quantum well or a multiple quantum well (MQW) structure in which a plurality of quantum wells and a plurality of barriers are alternately arranged. The thickness of the active layer 12 in the vertical direction (Z direction) or the number of quantum wells within the active layer 12 may be selected considering factors such as voltage applied to the first light-emitting element 10 and the light emission efficiency of the first light-emitting element 10. The active layer 12 may include a Group II-VI or Group III-V compound semiconductor material such as a nitride semiconductor material. For example, the active layer 12 may include at least one nitride semiconductor material selected from InGaN, GaN, AlGaN, and aluminum indium gallium nitride (AlInGaN).

When the active layer 12 includes indium (In), the wavelength of light emitted by the active layer 12 may decrease as the indium content of the active layer 12 decreases. For example, the active layer 12 may include a nitride semiconductor material such as InGaN or AlInGaN. In this case, the active layer 12 may emit red light having a wavelength of about 630 nm when the indium content in the nitride semiconductor material is about 35 atomic percentage (at%), yellow light having a wavelength of about 560 nm when the indium content is about 30 at%, and green light having a wavelength of about 520 nm when the indium content is about 25 at%. In addition, the active layer 12 may emit blue light having a wavelength of about 450 nm when the indium content is about 15 at%. For example, the active layer 12 of the first light-emitting element 10 may include an indium content of about 15 at% and may emit blue light.

The second light-emitting element 20 may be provided on the first light-emitting element 10. Similar to the first light-emitting element 10, the second light-emitting element 20 may include a first-type semiconductor layer 21, an active layer 22, and a second-type semiconductor layer 23 that form a vertically stacked structure. The first-type semiconductor layer 21 and the second-type semiconductor layer 23 of the second light-emitting element 20 may be the same as the first-type semiconductor layer 11 and the second-type semiconductor layer 13 of the first light-emitting element 10. For example, the first-type semiconductor layer 21 and the second-type semiconductor layer 23 of the second light-emitting element 20 may include at least one nitride semiconductor material selected from InAlGaN, GaN, AlGaN, InGaN, AlN, and InN.

The active layer 22 of the second light-emitting element 20 may have a nitride semiconductor material composition that is different from the nitride semiconductor material composition of the active layer 12 of the first light-emitting element 10. Thus, the second light-emitting element 20 may emit light in a different wavelength range from the first light-emitting element 10. The active layer 22 of the second light-emitting element 20 may have a greater indium content than an indium content of the active layer 12 of the first light-emitting element 10. For example, the active layer 22 of the second light-emitting element 20 may have an indium content of about 25 atomic percentage (at%) and may emit green light.

The third light-emitting element 30 may be provided on the second light-emitting element 20. Similar to the first light-emitting element 10 and the second light-emitting element 20, the third light-emitting element 30 may include a first-type semiconductor layer 31, an active layer 32, and a second-type semiconductor layer 33 that form a vertically stacked structure. The first-type semiconductor layer 31 and the second-type semiconductor layer 33 of the third light-emitting element 30 are the same as the first-type semiconductor layer 11 and the second-type semiconductor layer 13 of the first light-emitting element 10, and thus, repeated descriptions thereof are omitted. The active layer 32 of the third light-emitting element 30 may have a nitride semiconductor material composition that is different from the nitride semiconductor material composition of the active layer 12 of the first light-emitting element 10. For example, the active layer 32 of the third light-emitting element 30 may have an indium content of about 35 at% and may emit red light. A lower surface of the light-emitting structure 110 may be denoted with S1, and an upper surface of the light-emitting structure 110 may be denoted with S2. Referring to FIG. 1A, a surface of the first-type semiconductor layer 11 of the first light-emitting element 10 may be the lower surface S1, and a surface of the second-type semiconductor layer 33 of the third light-emitting element 30 may be the upper surface S2.

As the size of a light-emitting element decreases, the density of current applied to the light-emitting element increases. The increase of the current density reduces the external quantum efficiency (EQE) of the light-emitting element, and thus, the light emission efficiency of the light-emitting element may decrease. According to one or more embodiments, in the light-emitting device 100, the first to third light-emitting elements 10, 20, and 30 that emit light of different wavelengths are stacked in a vertical direction, that is, in a light-emission direction (for example, the Z-axis direction). As a result, the active layers 12, 22, and 32 may have relatively large areas. Because the active layers 12, 22, and 32 have relatively large areas, the density of current applied to the first to third light-emitting elements 10, 20, and 30 may be reduced. The reduced current density may increase the EQE and the light emission efficiency of the first to third light-emitting elements 10, 20, and 30.

For example, according to one or more embodiments, the widths of the first to third light-emitting elements 10, 20, and 30 may increase from the first light-emitting element 10 to the third light-emitting element 30. Here, the term "width" may refer to the average width of each light-emitting element in the horizontal direction (X direction and/or Y direction). For example, the widths of the active layers 12, 22, and 32 may increase from the first light-emitting element 10 to the third light-emitting element 30. For example, a width of the active layer 12 may be less than a width of the active layer 22, and the width of the active layer 22 may be less than a width of the active layer 32. Because the light emission efficiency of the active layer 32 of the third light-emitting element 30, which emits red light, is less than the light emission efficiencies of the active layers 11 and 12 of the first and second light-emitting element 10 and 20, the difference between the light emission efficiencies of the first to third light-emitting elements 10, 20, and 30 may be reduced by increasing an active area of the third light-emitting element 30.

Although key components for basic operations of the first light-emitting element 10, the second light-emitting element 20, and the third light-emitting element 30 have been described, embodiments are not limited thereto. At least one of the first light-emitting element 10, the second light-emitting element 20, and the third light-emitting element 30 may further include various additional layers to enhance performance. For example, a carrier blocking layer and/or stress relaxation layers may be further arranged between each of the first-type semiconductor layers 11, 21, and 31 and each of the active layers 12, 22, and 32, as well as between each of the active layers 12, 22, and 32 and each of the second-type semiconductor layers 13, 23, and 33. Hereinafter, for ease of description, key components for the basic operations of the first to third light-emitting elements 10, 20, and 30 will be described.

According to one or more embodiments, the light-emitting device 100 may further include a first electrode pattern 130 and a second electrode pattern 140. The first electrode pattern 130 may be provided on an outer surface and the lower surface S1 of the light-emitting structure 110 and apply voltages independently to the second-type semiconductor layers 13, 23, and 33 of the light-emitting structure 110. The second electrode pattern 140 may be provided on the outer surface and the lower surface S1 of the light-emitting structure 110 and apply a common voltage to the first-type semiconductor layers 11, 21, and 31 of the light-emitting structure 110. On the outer surface of the light-emitting structure 110, the first electrode pattern 130 may be provided on a first outer surface S3, and the second electrode pattern 140 may be provided on a second outer surface S4 that is different from the first outer surface S3. For example, when the light-emitting structure 110 has a tetragonal pillar shape, the first electrode pattern 130 may be provided on three outer surfaces of the light-emitting structure 110, and the second electrode pattern 140 may be provided on one outer surface of the light-emitting structure 110.

When holes are formed in the light-emitting structure 110 to form electrode patterns, light emission areas of the active layers 12, 22, and 32 of the light-emitting structure 110 may be reduced. However, because the first electrode pattern 130 and the second electrode pattern 140 of one or more embodiments are provided on the outer surface of the light-emitting structure 110, the first electrode pattern 130 and the second electrode pattern 140 do not affect the emission area of the light-emitting structure 110.

According to one or more embodiments, the first electrode pattern 130 and the second electrode pattern 140 may extend to the lower surface S1 of the light-emitting structure 110. Because the first electrode pattern 130 and the second electrode pattern 140 are exposed on one surface of the light-emitting structure 110, the first electrode pattern 130 and the second electrode pattern 140 may be more easily coupled to a voltage-providing module.

The light-emitting device 100 may further include an insulating layer 150 surrounding and adjacent to the light-emitting structure 110. The insulating layer 150 may be provided between the first electrode pattern 130 and the light-emitting structure 110 and between the second electrode pattern 140 and the light-emitting structure 110. The insulating layer 150 may include a plurality of openings including a first opening H1, a second opening H2, a third opening H3, a fourth opening H4, a fifth opening H5, and a sixth opening H6 to allow the first electrode pattern 130 and the second electrode pattern 140 to be connected to the light-emitting structure 110. For example, the insulating layer 150 may include a first insulating layer 151 provided on the lower surface S1 of the light-emitting structure 110, a second insulating layer 152 provided on the upper surface S2 of the light-emitting structure 110, a third insulating layer 153 provided on the first outer surface S3 of the light-emitting structure 110, and a fourth insulating layer 154 provided on the second outer surface S4 of the light-emitting structure 110. The insulating layer 150 may include silicon oxide (SiO₂), titanium oxide (TiO₂), silicon nitride (Si₃N₄), aluminum oxide (AlOₓ), aluminum oxynitride (AlOₓN_{y}), tantalum oxide (Ta₂O₅), titanium nitride (TiN), aluminum nitride (AlN), zirconium oxide (ZrO₂), titanium aluminum nitride (TiAlN), titanium silicon nitride (TiSiN), hafnium oxide (HfOₓ), or a combination thereof.

The first electrode pattern 130 may include a first electrode 131 electrically connected to the second-type semiconductor layer 13 of the first light-emitting element 10 through the first opening H1 of the third insulating layer 153, a second electrode 132 electrically connected to the second-type semiconductor layer 23 of the second light-emitting element 20 through the second opening H2 of the third insulating layer 153, and a third electrode 133 electrically connected to the second-type semiconductor layer 33 of the third light-emitting element 30 through the third opening H3 of the third insulating layer 153. The first electrode 131, the second electrode 132, and the third electrode 133 may be spaced apart from each other and may provide independent voltages to the second-type semiconductor layers 13, 23, and 33 corresponding thereto.

The second electrode pattern 140 may be electrically connected to the first-type semiconductor layer 11 of the first light-emitting element 10, the first-type semiconductor layer 21 of the second light-emitting element 20, and the first-type semiconductor layer 31 of the third light-emitting element 30 through the fourth opening H4, the fifth opening H5, and the sixth opening H6, respectively. The second electrode pattern 140 may be formed as a single layer. However, embodiments are not limited thereto. The second electrode pattern 140 may be formed as two or more layers.

The first electrode pattern 130 and the second electrode pattern 140 may include a conductive oxide such as indium tin oxide (ITO), indium zinc oxide (IZO), zinc oxide (ZnO), or indium tin zinc oxide (ITZO), a conductive polymer material such as poly3,4-ethylene dioxythiophene (PEDOT), or a metal material such as silver (Ag), gold (Au), platinum (Pt), nickel (Ni), chromium (Cr), and/or aluminum (Al).

Among the outer surfaces of the light-emitting structure 110, the first outer surface S3, on which the first electrode pattern 130 is formed, and the second outer surface S4, on which the second electrode pattern 140 is formed, may have different stepped patterns.

The first outer surface S3 may include convex portions C11, C12, and C13 (collectively referred to as C1) at which the second-type semiconductor layers 13, 23, and 33 of the light-emitting structure 110 protrude outward compared to the first-type semiconductor layers 11, 21, and 31 and the active layers 12, 22, and 32 that are adjacent to the second-type semiconductor layers 13, 23, and 33. In the context of the present disclosure, the convex portions C11, C12, and C13 (collectively referred to as C1) can also be denoted as protruded portions. For example, at the first outer surface S3, the second-type semiconductor layer 13 of the first light-emitting element 10 may protrude outward compared to the active layer 12 of the first light-emitting element 10 and the first-type semiconductor layer 21 of the second light-emitting element 20, the second-type semiconductor layer 23 of the second light-emitting element 20 may protrude outward compared to the active layer 22 of the second light-emitting element 20 and the first-type semiconductor layer 31 of the third light-emitting element 30, and the second-type semiconductor layer 33 of the third light-emitting element 30 may protrude outward compared to the active layer 32 of the third light-emitting element 30. As another example, the width of each of the second-type semiconductor layers 13, 23, and 33 of the light-emitting structure 110 in the horizontal direction (X direction and/or Y direction) may gradually increase in a vertical direction (Z direction) away from the lower surface S1 of the light-emitting structure 110. For example, each of the second-type semiconductor layers 13, 23, and 33 may have an inverted trapezoidal cross-section with a width in the horizontal direction (X direction and/or Y direction) gradually increasing in the vertical direction (Z direction) away from the lower surface S1 of the light-emitting structure 110.

At least one of the first to third openings H1, H2, and H3 of the insulating layer 150 may be provided on the convex portions C11, C12, and C13 of the first outer surface S3, for example, on outer surfaces of the second-type semiconductor layers 13, 23, and 33. For example, on the first outer surface S3, the first opening H1 may be provided on the outer surface of the second-type semiconductor layer 13 of the first light-emitting element 10, the second opening H2 may be provided on the outer surface of the second-type semiconductor layer 23 of the second light-emitting element 20, and the third opening H3 may be provided on the outer surface of the second-type semiconductor layer 33 of the third light-emitting element 30. The first electrode 131 may be in contact with the second-type semiconductor layer 13 of the first light-emitting element 10 that is exposed through the first opening H1, the second electrode 132 may be in contact with the second-type semiconductor layer 23 of the second light-emitting element 20 that is exposed through the second opening H2, and the third electrode 133 may be in contact with the second-type semiconductor layer 33 of the third light-emitting element 30 that is exposed through the third opening H3. The first electrode 131, the second electrode 132, and the third electrode 133 may be provided on the first outer surface S3 of the light-emitting structure 110 and may extend to the lower surface S1 of the light-emitting structure 110.

At the first outer surface S3, the second-type semiconductor layers 13, 23, and 33 of the light-emitting structure 110 protrude outward compared to adjacent layers, and thus, the first electrode pattern 130 may be more easily brought into contact with the second-type semiconductor layers 13, 23, and 33 of the light-emitting structure 110.

The second outer surface S4 may include concave portions C2 at which at least one of the first-type semiconductor layers 11, 21, and 31 of the light-emitting structure 110 is recessed inward. In the context of the present disclosure, concave portions C2 can also be denoted as recessed portions. For example, on the second outer surface S4, the first-type semiconductor layer 11 of the first light-emitting element 10 may include a concave region C21 that is stepped a plurality of times, the first-type semiconductor layer 21 of the second light-emitting element 20 may include a concave region C22 that is stepped a plurality of times, and the first-type semiconductor layer 31 of the third light-emitting element 30 may include a concave region C23 that is stepped a plurality of times. For example, on the second outer surface S4, at least one of the first-type semiconductor layers 11, 21, and 31 may include four or more surfaces having different inclination angles with respect to the thickness direction (Z direction) of the light-emitting structure 110.

The concave portions C2 may be filled with the second electrode pattern 140. At least one of the fourth to sixth openings H4, H5, and H6 of the fourth insulating layer 154 may be provided on the concave portions C2 of the second outer surface S4, for example, on outer surfaces of the first-type semiconductor layers 11, 21, and 31. For example, on the second outer surface S4, the fourth opening H4 may be provided on the concave region C21 of the first-type semiconductor layer 11 of the first light-emitting element 10, the fifth opening H5 may be provided on the concave region C22 of the first-type semiconductor layer 21 of the second light-emitting element 20, and the sixth opening H6 may be provided on the concave region C23 of the first-type semiconductor layer 31 of the third light-emitting element 30. The second electrode pattern 140 may extend to the lower surface S1 of the light-emitting structure 110 while filling the concave regions C21, C22, and C23 of the first-type semiconductor layers 11, 21, and 31 that are exposed on the second outer surface S4 through the fourth opening H4, the fifth opening H5, and the sixth opening H6.

On the second outer surface S4, some regions of the first-type semiconductor layers 11, 21, and 31 of the light-emitting structure 110 include the concave portions C2 recessed into the light-emitting structure 110, and the second electrode pattern 140 is formed as a single layer filling the concave portions C2. Thus, the second electrode pattern 140 may be more easily brought into contact with the first-type semiconductor layers 11, 21, and 31 of the light-emitting structure 110. In addition, the second electrode pattern 140 may also be in contact with lateral surfaces of the first-type semiconductor layers 11, 21, and 31, and thus, the contact area between the second electrode pattern 140 and the first-type semiconductor layers 11, 21, and 31 may be increased.

Outer surfaces of the active layers 12, 22, and 32 and the second-type semiconductor layers 13, 23, and 33 that are included in the second outer surface S4 may be inclined at a predetermined angle with respect to the thickness direction (Z direction) of the light-emitting structure 110. Here, the predetermined angle may be from about 5 degrees to about 30 degrees.

In the above embodiments, it has been described that the light-emitting device 100 includes three light-emitting elements configured to emit light of different wavelengths. However, embodiments are not limited thereto. The light-emitting device 100 may include two light-emitting elements configured to emit light of different wavelengths, or four or more light-emitting elements configured to emit light of different wavelengths. In addition, the light-emitting device 100 may emit light in the visible light spectrum and may also emit light in the non-visible light spectrum.

According to one or more embodiments, the light-emitting device 100 is capable of emitting light of different wavelengths and may thus be used as a pixel in a display apparatus. The light-emitting device 100 may operate as a single pixel, and thus, the display apparatus may have a relatively small size and high resolution.

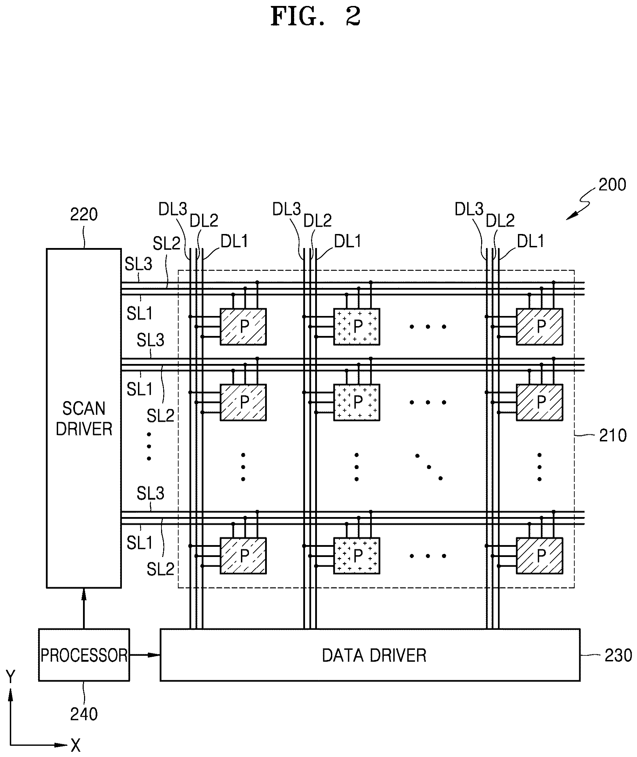

FIG.2 is a block diagram illustrating a display apparatus 200 including the light-emitting device 100, according to one or more embodiments. Referring to FIG. 2, the display apparatus 200 may include a pixel array 210, a scan driver 220, a data driver 230, and a processor 240. The pixel array 210 may include a plurality of pixels P provided in a two-dimensional array form, a plurality of scan line sets that transmit scan signals to the pixels P, and a plurality of data line sets that transmit data signals to the pixels P.

At least one of the pixels P of the pixel array 210 may include the light-emitting device 100 described above. For example, at least one of the pixels P may include the light-emitting device 100, a first transistor TR1, a second transistor TR2, a third transistor TR3, and a fourth transistor TR4 electrically connected to the light-emitting device 100. The light-emitting device 100 may include the first light-emitting element 10 emitting blue light, the second light-emitting element 20 emitting green light, and the third light-emitting element 30 emitting red light.

Each of the scan line sets may include a first scan line SL1, a second scan line SL2, and a third scan line SL3 that extend in an X direction. Each of the first scan line SL1, the second scan line SL2, and the third scan line SL3 may be connected to a plurality of pixels P arranged in the X direction. For example, the first scan line SL1 may be electrically connected to gate electrodes G of first transistors TR1 of the pixels P, the second scan line SL2 may be electrically connected to gate electrodes G of second transistors TR2 of the pixels P, and the third scan line SL3 may be electrically connected to gate electrodes G of third transistors TR3 in the pixels P. The first scan line SL1, the second scan line SL2, and the third scan line SL3 may also be connected to the scan driver 220 to receive scan signals from the scan driver 220.

Each of the data line sets may include a first data line DL1, a second data line DL2, and a third data line DL3 that extend in a Y direction. Each of the first data line DL1, the second data line DL2, and the third data line DL3 may be connected to a plurality of pixels P arranged in the Y direction. For example, the first data line DL1 may be electrically connected to source horizontal lines of first transistors TR1 of the pixels P, the second data line DL2 may be electrically connected to source horizontal lines of second transistors TR2 of the pixels P, and the third data line DL3 may be connected to source horizontal lines of third transistors TR3 in the pixels P. The first data line DL1, the second data line DL2, and the third data line DL3 may also be connected to the data driver 230 to receive data signals from the data driver 230.

The processor 240 may control operations of the scan driver 220 and the data driver 230 based on image data to be displayed on the pixel array 210, thereby adjusting a scan signal and a data signal provided to each of the pixels P.

FIG. 3A is a cross-sectional view illustrating a portion of a display apparatus 200 including a light-emitting device 100, according to one or more embodiments. FIG. 3B is another cross-sectional view illustrating the display apparatus 200 of FIG. 3A.

Referring to FIGS. 3A and 3B, the display apparatus 200 may include a display layer 310 including a plurality of light-emitting devices, a driving layer 320 configured to drive the light-emitting devices, and a substrate 330 supporting the driving layer 320. The driving layer 320 and the substrate 330 may be collectively referred to as a backplane 301.

The display layer 310 may include the light-emitting devices. At least one of the light-emitting devices may include a plurality of light-emitting elements including a first light-emitting element 10, a second light-emitting element 20, and a third light-emitting element 30 connected to emit light of different wavelengths. From the perspective of the display apparatus 200, the first light-emitting element 10 may be a component of a first subpixel, the second light-emitting element 20 may be a component of a second subpixel, and the third light-emitting element 30 may be a component of a third subpixel. The light-emitting devices have been described above, and thus, repeated descriptions thereof are omitted.

The substrate 330 may include an insulating material such as glass, an organic polymer, or quartz. In addition, the substrate 330 may include a flexible material that allows bending or folding and may have a single-layer structure or a multi-layer structure.

The driving layer 320 may include a buffer layer 321 provided on the substrate 330 and first to fourth transistors TR1, TR2, TR3, and TR4 provided on the buffer layer 321. The driving layer 320 may further include driving voltage wiring, a scan driver 220, a data driver 230, and a processor 240 (as shown in FIG. 2), but these components are not shown in FIGS. 3A and 3B.

The buffer layer 321 may prevent the diffusion of impurities into the first to fourth transistors TR1, TR2, TR3, and TR4. The buffer layer 321 may be provided as a single layer or may have a multi-layer structure with at least two layers.

When the buffer layer 321 has a multi-layer structure, layers of the multi-layer structure may include the same material or different materials. The buffer layer 321 may be omitted depending on a material of the substrate 330 and process conditions.

The first to fourth transistors TR1, TR2, and TR3 may drive corresponding light-emitting elements among the light-emitting elements included in the display layer 310. For example, the driving layer 320 may include the first transistor TR1 that drives the first light-emitting element 10, the second transistor TR2 that drives the second light-emitting element 20, and the third transistor TR3 that drives the third light-emitting element 30. The driving layer 320 may further include the fourth transistor TR4 that applies a common voltage to the first to third light-emitting elements 10, 20, and 30. Each of the first to fourth transistors TR1, TR2, TR3, and TR4 may include a semiconductor layer, a gate electrode, a source electrode, and a drain electrode.

The semiconductor layer may be provided on the buffer layer 321. The semiconductor layer may include a source region that is in contact with the source electrode and a drain region that is in contact with the drain electrode. A region between the source region and the drain region may be a channel region.

The semiconductor layer may be a semiconductor pattern including polycrystalline silicon, amorphous silicon, or an oxide semiconductor. The channel region may be an intrinsic semiconductor pattern that is not doped with a dopant. The source and drain regions may be semiconductor patterns doped with a dopant.

The gate electrode may be provided on the semiconductor layer with a gate insulating layer 150 being between the gate electrode and the semiconductor layer.

The source electrode and the drain electrode may respectively be in contact with the source and drain regions of the semiconductor layer through contact holes penetrating an interlayer insulating layer 323 and a gate insulating layer 322.

A protective layer 324 may be provided on the first to fourth transistors TR1, TR2, TR3, and TR4. The protective layer 324 may include a first conductive via CV1, a second conductive via CV2, a third conductive via CV3, and a fourth conductive via CV4. The first electrode 131 may be electrically connected to the first transistor TR1 (for example, a drain of the first transistor TR1) through the first conductive via CV1 and a first electrode pad E1. The second electrode 132 may be electrically connected to the second transistor TR2 (for example, a drain of the second transistor TR2) through the second conductive via CV2 and a second electrode pad E2. The third electrode 133 may be electrically connected to the third transistor TR3 (for example, a drain of the third transistor) through the third conductive via CV3 and a third electrode pad E3. Furthermore, a second electrode pattern 140 may be electrically connected to the fourth transistor TR4 (for example, a drain of the first transistor TR4) through the fourth conductive via CV4 and a fourth electrode pad E4.

When driving voltages are applied through a first electrode pattern 130 and a common voltage is applied through the second electrode pattern 140, each of the first to third light-emitting element 10, 20, and 30 may independently emit light based on the applied voltages.

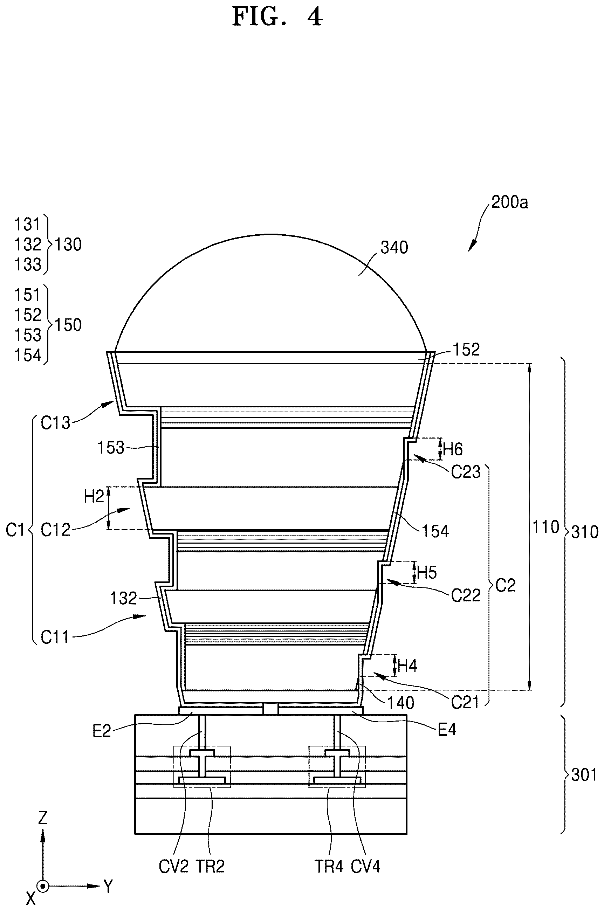

FIG. 4 is a view illustrating a display apparatus 200a including an optical layer 340 configured to adjust a light path, according to one or more embodiments.

Referring to FIGS. 3B and 4, the display apparatus 200a shown in FIG. 4 may include the optical layer 340 provided on a display layer 310 and configured to adjust the propagation path of light emitted from the display layer 310. The optical layer 340 may include a plurality of microlenses corresponding one-to-one to a plurality of light-emitting devices. Each of the microlenses may adjust the propagation path of light emitted from a corresponding light-emitting device and guide the light in a specific direction. The microlenses have different refractive indexes and are thus capable of focusing light emitted from the display layer 310. Therefore, the display apparatus 200a may generate an image with a narrow viewing angle. In addition, the optical layer 340 may magnify or reduce an image produced by the display layer 310 depending on the application of the display apparatus 200a. Furthermore, the optical layer 340 may prevent mixing of light beams emitted from adjacent light-emitting devices.

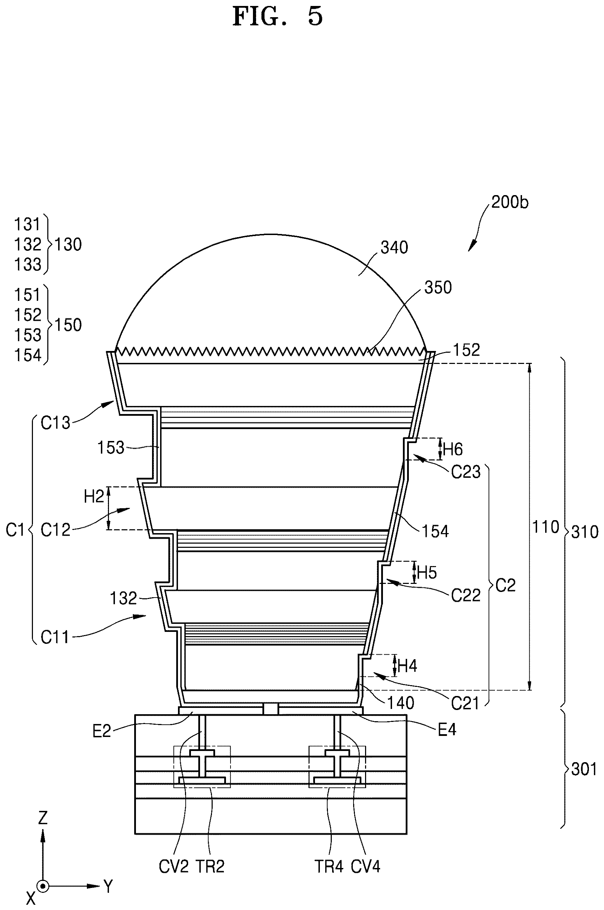

FIG. 5 is a view illustrating a display apparatus 200b including a scattering pattern 350, according to one or more embodiments.

Referring to FIGS. 4 and 5, the display apparatus 200b shown in FIG. 5 may further include the scattering pattern 350 provided on a display layer 310 and configured to scatter light emitted from the display layer 310. The scattering pattern 350 may be provided on a second insulating layer 152 provided on an upper surface of a light-emitting structure. An optical layer 340 may be provided on the scattering pattern 350. Among light beams emitted from active layers 12, 22, and 32 of the light-emitting structure, light beams incident onto the second insulating layer 152 with an incident angle greater than a critical angle pass through the second insulating layer 152 and propagate externally, and the other light beams are totally internally reflected back into the light-emitting structure. Light trapped inside the display layer 310 by the total internal reflection may be one of factors that reduce the light extraction efficiency of the display layer 310. For example, the scattering pattern 350 may be a concave-convex pattern capable of scattering light. Light emitted from the active layers 12, 22, and 32 of the light-emitting structure onto the scattering pattern 350 is scattered by the scattering pattern 350. As a result, the light emitted from the display layer 310 exhibits a uniform light intensity distribution. In addition, when light trapped inside the display layer 310 due to total internal reflection is incident on the scattering pattern 350, the light is scattered, and thus, the propagation direction of the light is changed. As described above, the scattering pattern 350 scatters light that is trapped inside the display layer 310 by total internal reflection and thus changes the propagation direction of the light. As a result, the light is output from the display layer 310. This enables the implementation of a display apparatus with improved light extraction efficiency.

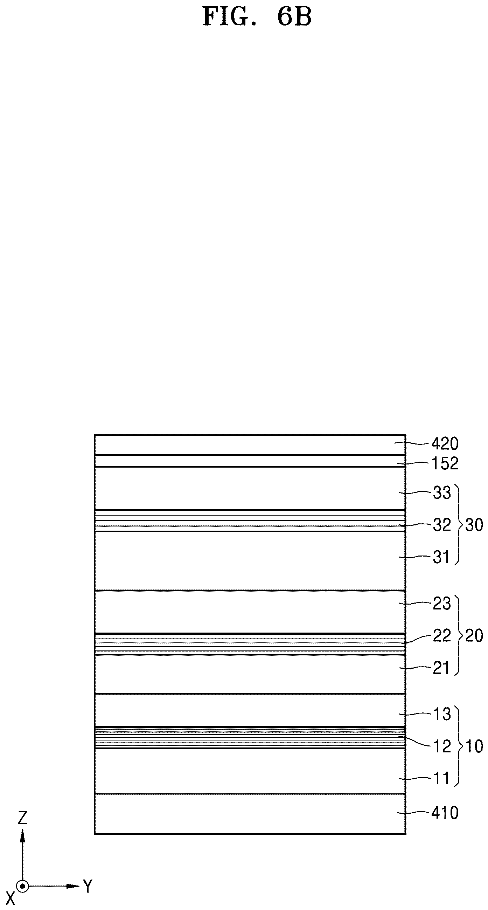

FIGS. 6A to 14B are cross-sectional views sequentially illustrating operations in a method of manufacturing a display apparatus, according to one or more embodiments. FIGS. 6A, 7A, 8A, 9A, 10A, 11A, 12A, 13A, and 14A are reference views illustrating the manufacturing method in relation to the cross-sectional view of the display apparatus 200 shown in FIG. 3A. FIGS. 6B, 7B, 8B, 9B, 10B, 11B, 12B, 13B, and 14B are reference views illustrating the manufacturing method in relation to the cross-sectional view of the display apparatus 200 shown in FIG. 3B.

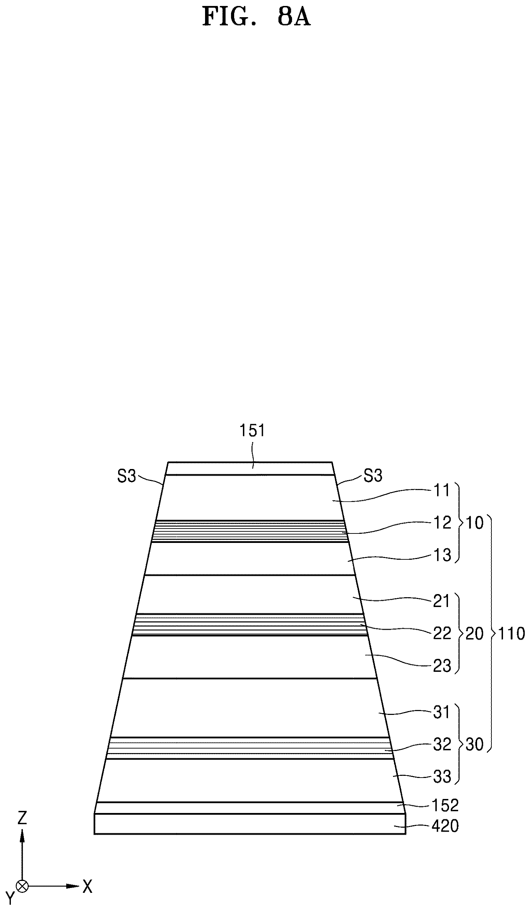

Referring to FIGS. 6A and 6B, a light-emitting structure 110 (refer to FIG. 8A) may be formed on a growth substrate 410. The growth substrate 410 may serve as a layer for growing the light-emitting structure 110. The growth substrate 410 may be a substrate for semiconductor single-crystal growth, such as a silicon (Si) substrate, a silicon carbide (SiC) substrate, or a sapphire substrate. In addition, the growth substrate 410 may be a substrate including a material suitable for the growth of the light-emitting structure 110, such as aluminum nitride (AlN), aluminum gallium nitride (AlGaN), zinc oxide (ZnO), gallium arsenide (GaAs), magnesium aluminum oxide (MgAl₂O₄), magnesium oxide (MgO), lithium aluminum oxide (LiAlO₂), lithium gallium oxide (LiGaO₂), or gallium nitride (GaN). A buffer layer may be provided on a surface of the growth substrate 410 for the epitaxial growth of the light-emitting structure 110, and the light-emitting structure may be grown on the buffer layer.

A first light-emitting element 10, a second light-emitting element 20, and a third light-emitting element 30 may be sequentially and vertically formed on the growth substrate 410. For example, a first-type semiconductor layer 11, an active layer 12, and a second-type semiconductor layer 13 of the first light-emitting element 10 may be sequentially grown on the growth substrate 410. Then, a first-type semiconductor layer 21, an active layer 22, and a second-type semiconductor layer 23 of the second light-emitting element 20 may be sequentially grown on the second-type semiconductor layer 13 of the first light-emitting element 10. Then, a first-type semiconductor layer 31, an active layer 32, and a second-type semiconductor layer 33 of the third light-emitting element 30 may be sequentially grown on the second-type semiconductor layer 23 of the second light-emitting element 20.

Among the first to third light-emitting elements 10, 20, and 30, the indium content in the active layer 12 of the first light-emitting element 10 is the lowest, and the indium content in the active layer 32 of the third light-emitting element 30 is the highest. For example, the indium content in the active layer 12 of the first light-emitting element 10 is less than the indium content of the active layer 22 of the second light-emitting element 20, and the indium content in the second light-emitting element 20 is less than the indium content in the active layer 32 of the light-emitting element 30. As the indium content decreases, the growth temperature of a nitride semiconductor increases. Therefore, an active layer requiring a relatively high growth temperature may first be grown, and an active layer requiring a relatively low growth temperature may later be grown. When an active layer with a relatively high indium content is grown first and an active layer with a relatively low indium content is grown later, the active layer with a relatively high indium content may deteriorate. According to one or more embodiments, the growth sequence of the light-emitting structure 110 may prevent the deterioration of the active layer 32 of the third light-emitting element 30, which has a relatively high indium content.

According to one or more embodiments, the light-emitting structure 110 is monolithically formed by sequentially forming the first light-emitting element 10, second light-emitting element 20, and third light-emitting element 30, and thus, a bonding material may not be provided between the first to third light-emitting elements 10, 20, and 30.

The light-emitting structure 110 may be formed using a method such as metal organic chemical vapor deposition (MOCVD), chemical vapor deposition (CVD), plasma-enhanced chemical vapor deposition (PECVD), molecular beam epitaxy (MBE), or hydride vapor phase epitaxy (HVPE).

A second insulating layer 152 and a sacrificial layer 420 may be further formed on an upper surface of the light-emitting structure 110. The second insulating layer 152 may include SiO₂ or the like, and the sacrificial layer 420 may include silicon (Si), silicon carbide (SiC), sapphire, or the like. The second insulating layer 152 and the sacrificial layer 420 may be formed through a chemical vapor deposition (CVD) process.

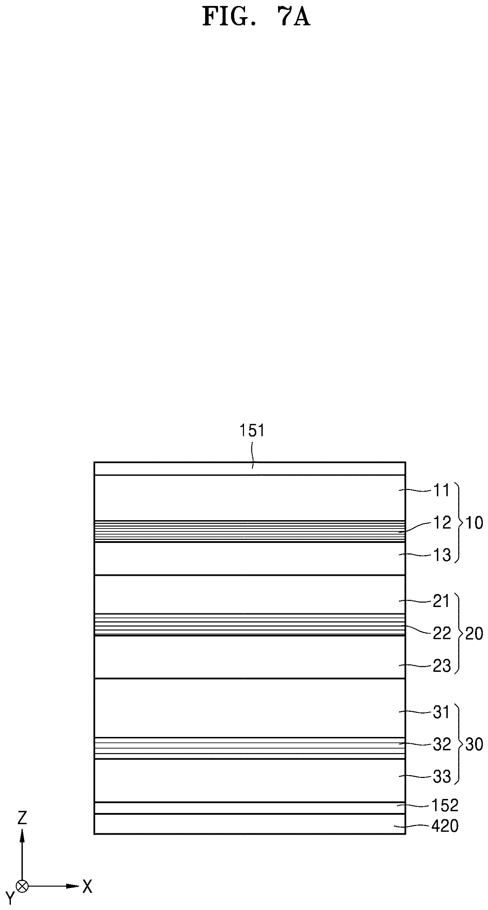

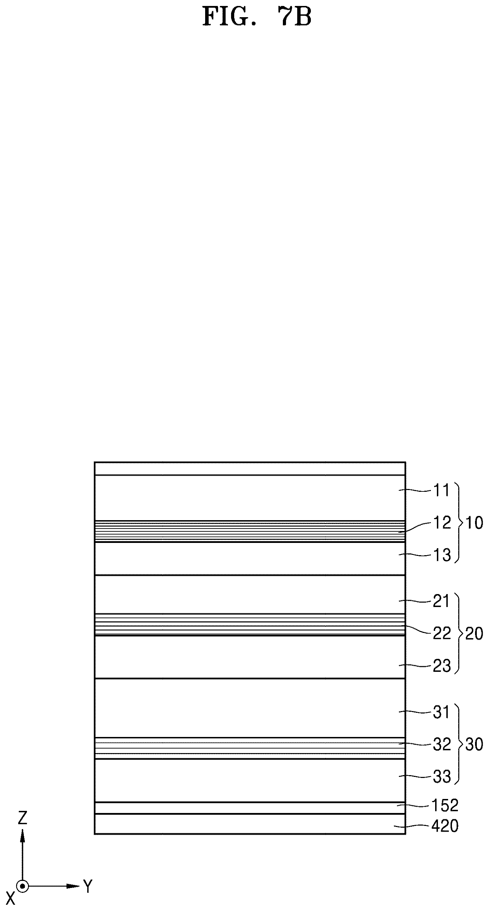

Referring to FIGS. 7A and 7B, after inverting the light-emitting structure 110 in the vertical direction (Z direction), the growth substrate 410 is removed, and a first insulating layer 151 may be formed on an exposed surface of the first-type semiconductor layer 11 of the first light-emitting element 10. Before forming the first insulating layer 151, a chemical mechanical polishing (CMP) process may be performed to planarize an exposed surface of the first light-emitting element 10.

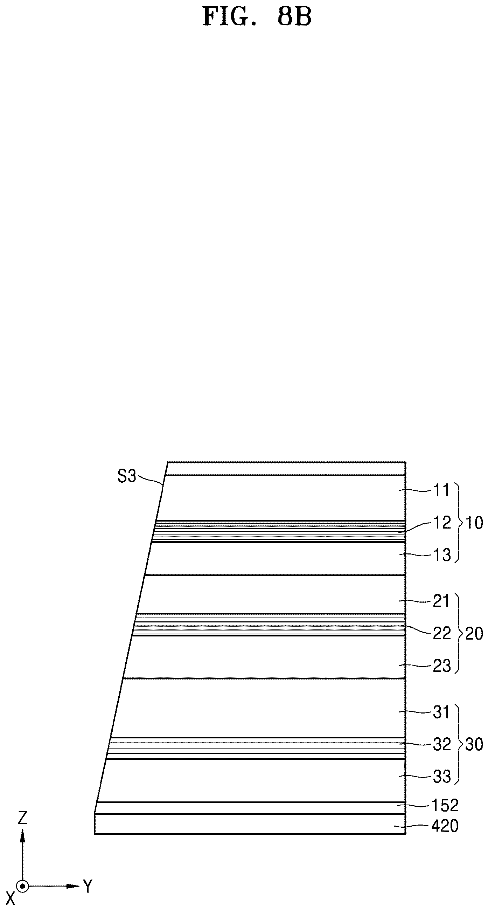

Referring to FIGS. 8A and 8B, a portion of an outer surface of the light-emitting structure 110 may be mesa etched to form a first outer surface S3. The first outer surface S3 may be inclined at a certain angle with respect to the thickness direction (Z direction) of the light-emitting structure 110. For example, the light-emitting structure 110 is etched such that the width of the light-emitting structure 110 in the horizontal direction (X direction and/or Y direction) may gradually increase in the vertical direction (Z direction) from the first light-emitting element 10 toward the second light-emitting element 20. The etching may be performed through a dry etching process or a wet etching process. For instance, the dry etching process may use inductively coupled plasma (ICP).

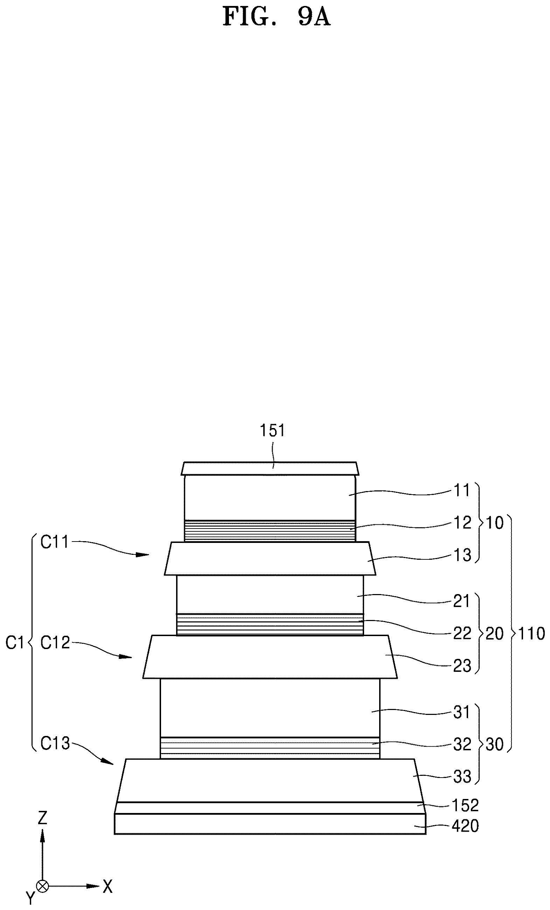

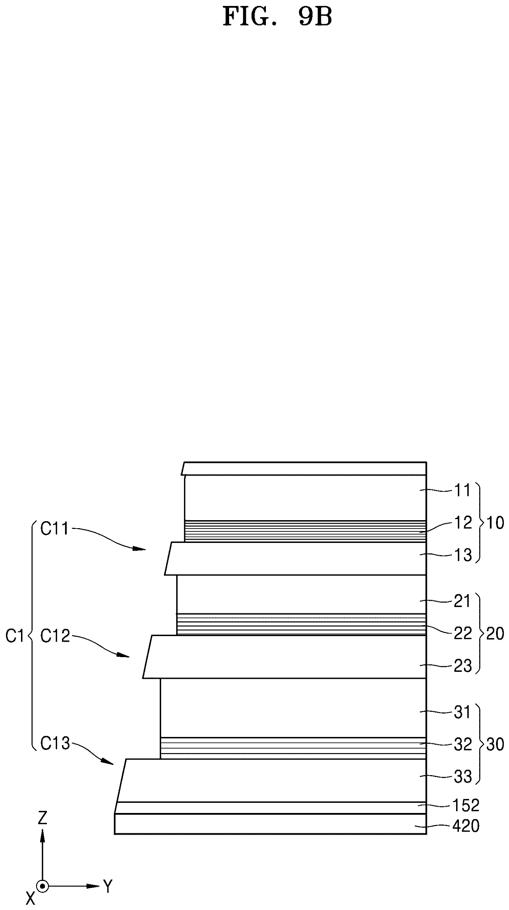

Referring to FIGS. 9A and 9B, protrusions C11, C12, and C13 (collectively referred to as C1) protruding outward from the second-type semiconductor layers 13, 23, and 33 may be formed on the first outer surface S3. The protrusions C11, C12, and C13 may be formed by selectively etching the first-type semiconductor layers 11, 21, and 31 and the active layers 12, 22, and 32 from the first outer surface S3 of the light-emitting structure 110, respectively. The etching may be performed using an OH-based etchant such as a potassium hydroxide (KOH) solution or a tetramethyl ammonium hydroxide (TMAH) solution. The etching rate of the OH-based etchant for GaN-based materials depends on whether the GaN-based materials are doped and the types of dopants used. For example, the etching rate of the OH-based etchant for n-GaN is significantly greater than for p-GaN. The OH-based etchant etches n-GaN at a very high rate but etches p-GaN at a negligibly low rate. Thus, first-conductive-type material layers, which are n-GaN layers, and the active layers 12, 22, and 32 may be selectively etched.

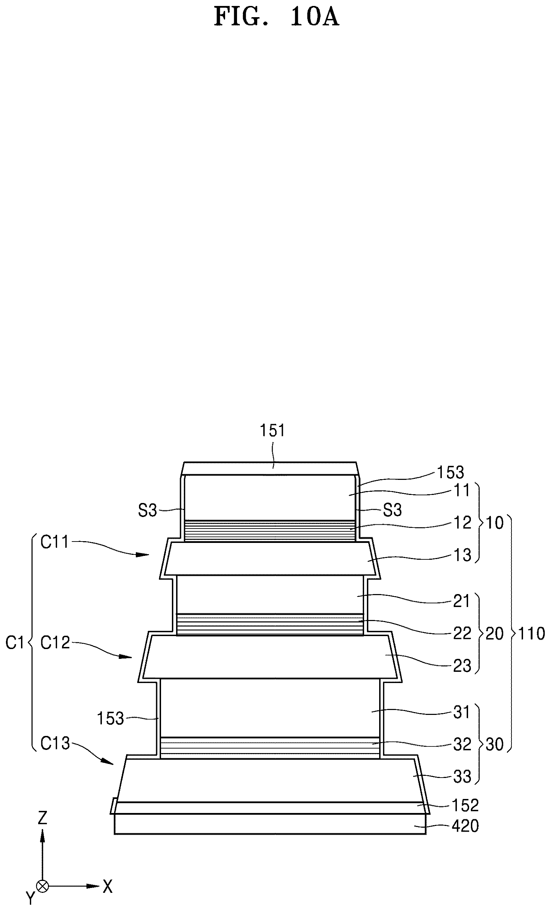

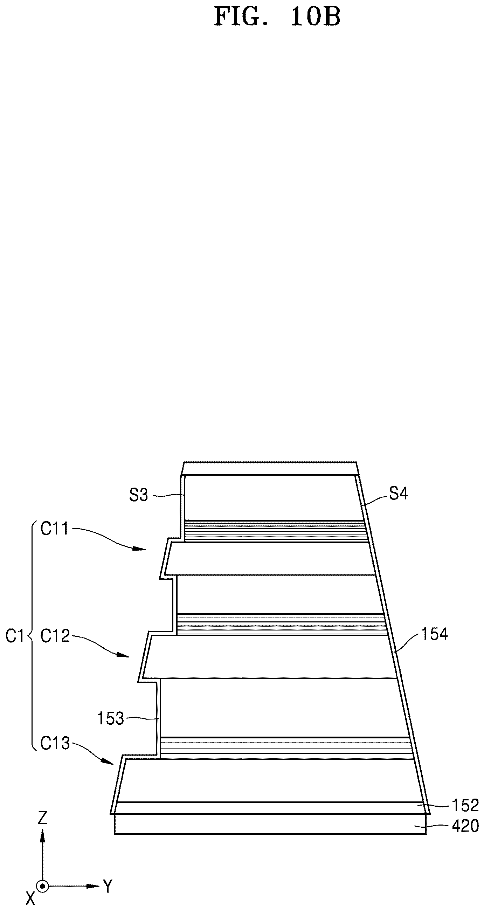

Referring to FIGS. 10A and 10B, the remaining region of the outer surface of the light-emitting structure 110 may be mesa etched to form a second outer surface S4. The second outer surface S4 may be inclined at a certain angle with respect to the thickness direction (Z direction) of the light-emitting structure 110. For example, the etching is performed such that the width of the light-emitting structure 110 in the horizontal direction (X direction and/or Y direction) may gradually increase in the vertical direction (Z direction) from the first light-emitting element 10 toward the second light-emitting element 20. The etching may be performed using a dry etching process. For instance, the dry etching process may be performed using ICP.

Third and fourth Insulating layers 153 and 154 may be formed on the outer surface of the light-emitting structure 110, that is, respectively on the first outer surface S3 and the second outer surface S4. The third insulating layer 153 and the fourth insulating layer 154 may include the same material and may be formed using the same process. The third and fourth insulating layers 153 and 154 may be formed by sputtering, atomic layer deposition (ALD), plasma-enhanced atomic layer deposition (PEALD), CVD, PECVD, physical vapor deposition (PVD), another known method, or a combination thereof. According to one or more embodiments, the third and fourth insulating layers 153 and 154 may include a transparent insulating material and are formed by ALD.

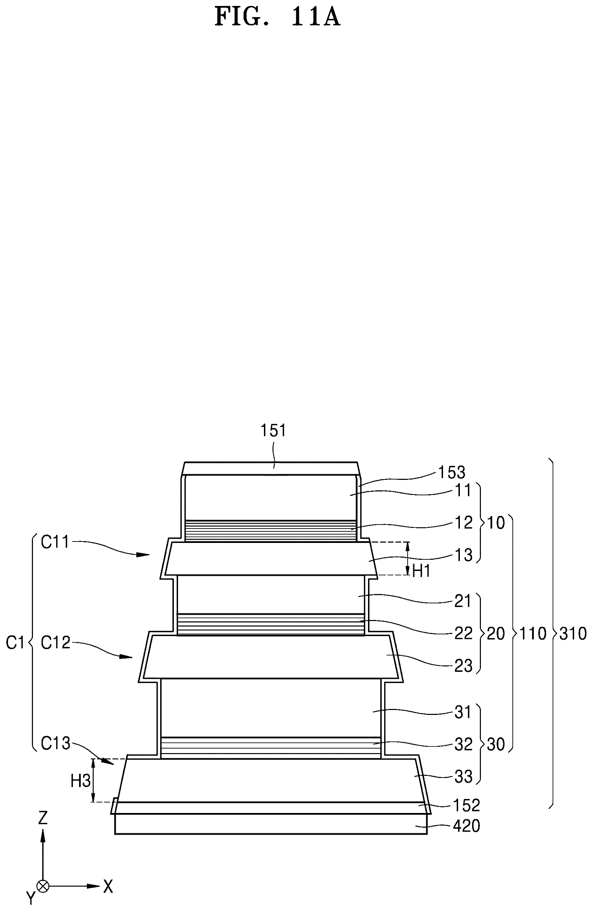

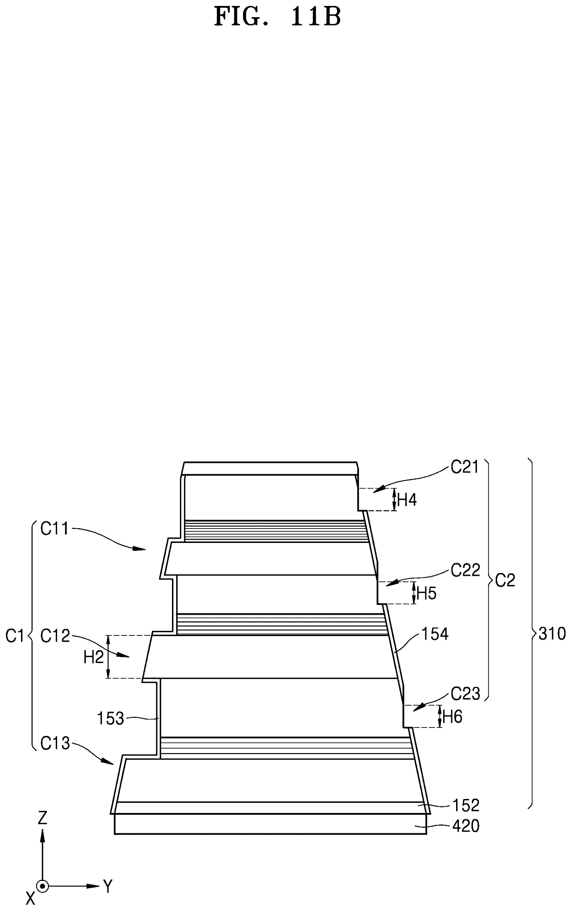

Referring to FIGS. 11A and 11B, a plurality of openings including first to sixth openings H1, H2, H3, H4, H5, and H6 may be formed in the third and fourth insulating layers 153 and 154, and concave portions C2 may be formed in the second outer surface S4 of the light-emitting structure 110. For example, the second-type semiconductor layers 13, 23, and 33 of the light-emitting structure 110 may be exposed by forming the first to third openings H1, H2, and H3 in the third insulating layer 153 provided on the first outer surface S3 of the light-emitting structure 110. In addition, the first-type semiconductor layers 11, 21, and 31 of the light-emitting structure 110 may be exposed by forming the fourth to sixth openings H4, H5, and H6 in the fourth insulating layer 154 provided on the second outer surface S4 of the light-emitting structure 110. The concave portions C2 may be formed in the first-type semiconductor layers 11, 21, and 31 by etching exposed portions of the first-type semiconductor layers 11, 21, and 31. The first to sixth openings H1, H2, H3, H4, H5, and H6 and the concave portions C2 (C21, C22, and C23) may be formed using a dry etching process.

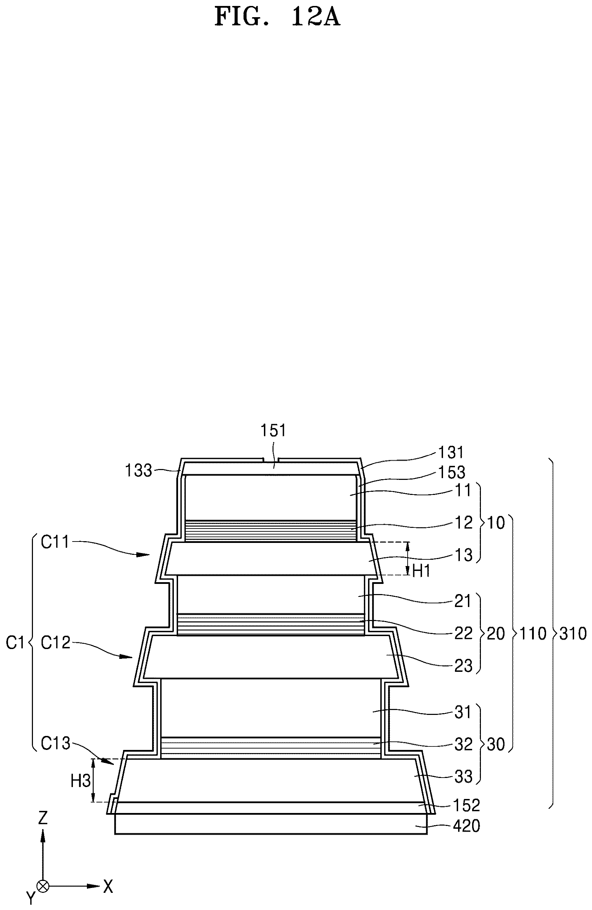

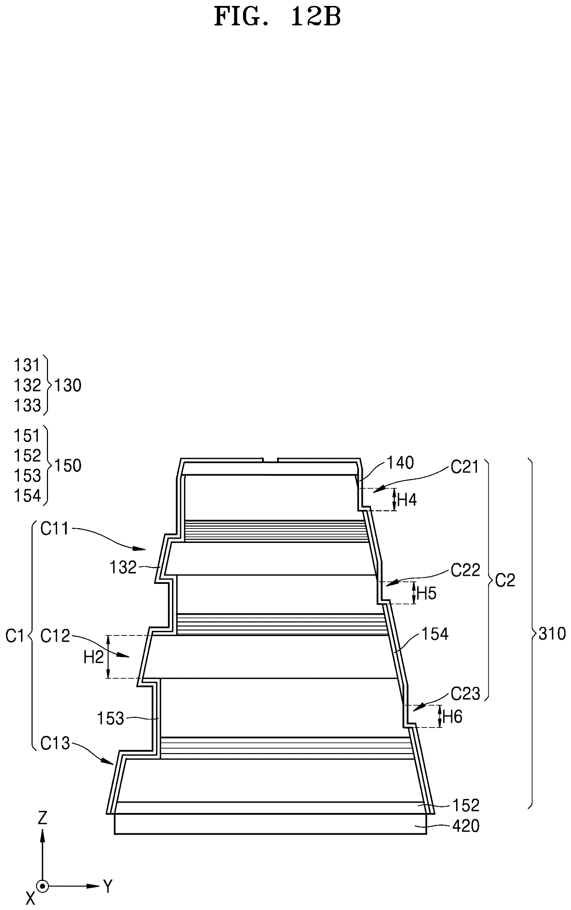

Referring to FIGS. 12A and 12B, a first electrode pattern 130 and a second electrode pattern 140 may be formed on the light-emitting structure 110. The first electrode pattern 130 may be formed on the third insulating layer 153 and the first insulating layer 151 by forming a first electrode 131 that is in contact with the second-type semiconductor layer 13 of the first light-emitting element 10 through the first opening H1, a second electrode 132 that is in contact with the second-type semiconductor layer 23 of the second light-emitting element 20 through the second opening H2, and a third electrode 133 that is in contact with the second-type semiconductor layer 33 of the third light-emitting element 30 through the third opening H3. The second electrode pattern 140 may be formed on the fourth insulating layer 154 and the first insulating layer 151 such that the second electrode pattern 140 may be in contact with the first-type semiconductor layers 11, 21, and 31 of the light-emitting structure 110 through the fourth opening H4, the fifth opening H5, and the sixth opening H6. The first electrode pattern 130 and the second electrode pattern 140 may include a transparent conductive material such as ITO, a metal such as aluminum (Al), titanium (Ti), platinum (Pt), silver (Ag), gold (Au), palladium (Pd), or titanium tungsten (TiW), or a combination thereof. The first electrode pattern 130 and the second electrode pattern 140 may be formed using a method such as sputtering, ALD, PEALD, CVD, PECVD, PVD, another method, or a combination thereof. According to one or more embodiments, the first electrode pattern 130 and the second electrode pattern 140 may be formed using ALD.

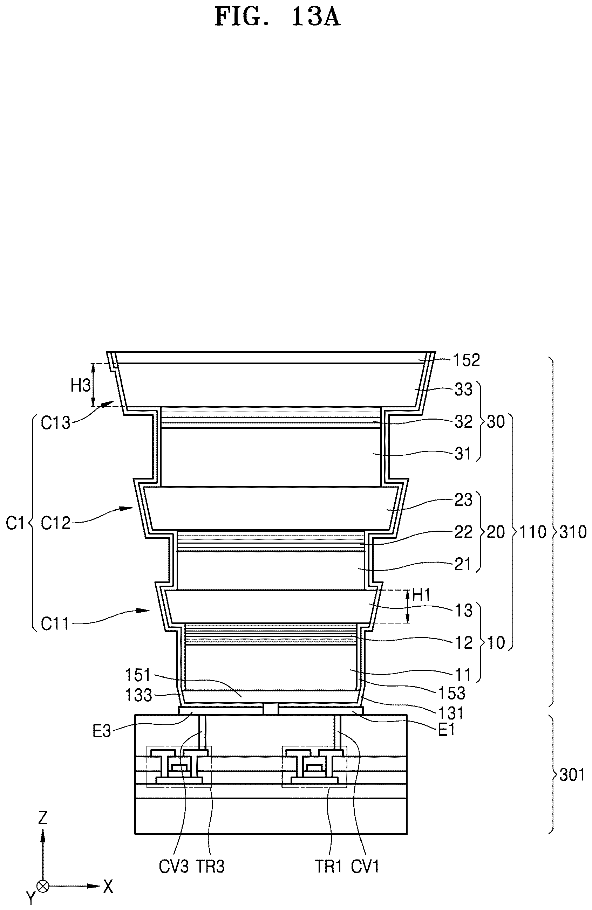

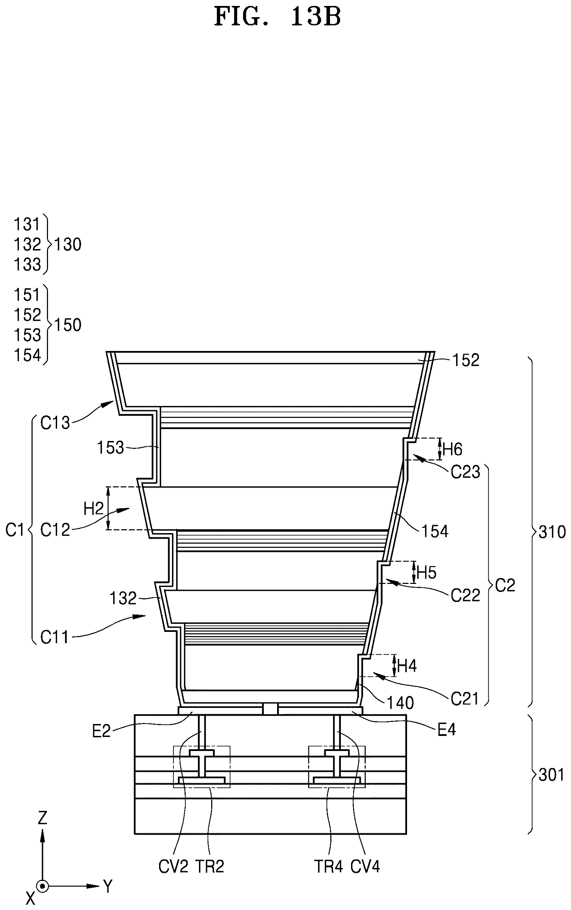

Referring to FIGS. 13A and 13B, after bonding the first electrode pattern 130 and the second electrode pattern 140 to a backplane 301, the sacrificial layer 420 may be removed. The backplane 301 may include a first transistor TR1, a second transistor TR2, and a third transistor TR3 that respectively drive the first light-emitting element 10, the second light-emitting element 20, and the third light-emitting element 30. In addition, the backplane 301 may include a fourth transistor TR4 that applies a common voltage to the light-emitting structure 110. A first electrode pad E1, a second electrode pad E2, a third electrode pad E3, and a fourth electrode pad E4 are arranged on a surface of the backplane 301 and are electrically connected to the first transistor TR1, the second transistor TR2, the third transistor TR3, and the fourth transistor TR4, respectively. The first electrode pad E1, the second electrode pad E2, the third electrode pad E3, and the fourth electrode pad E4 are connected one-to-one to the first electrode 131, the second electrode 132, the third electrode 133, and the second electrode pattern 140, and thus, the backplane 301 may be bonded to a light-emitting device 100. The backplane 301 may include various circuit modules in addition to the first to fourth transistors TR1, TR2, TR3, and TR4.

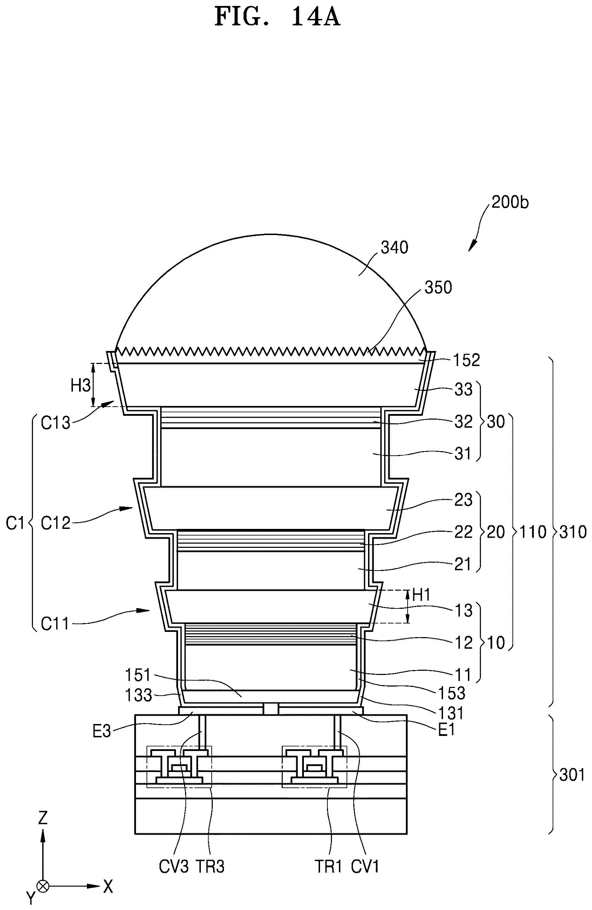

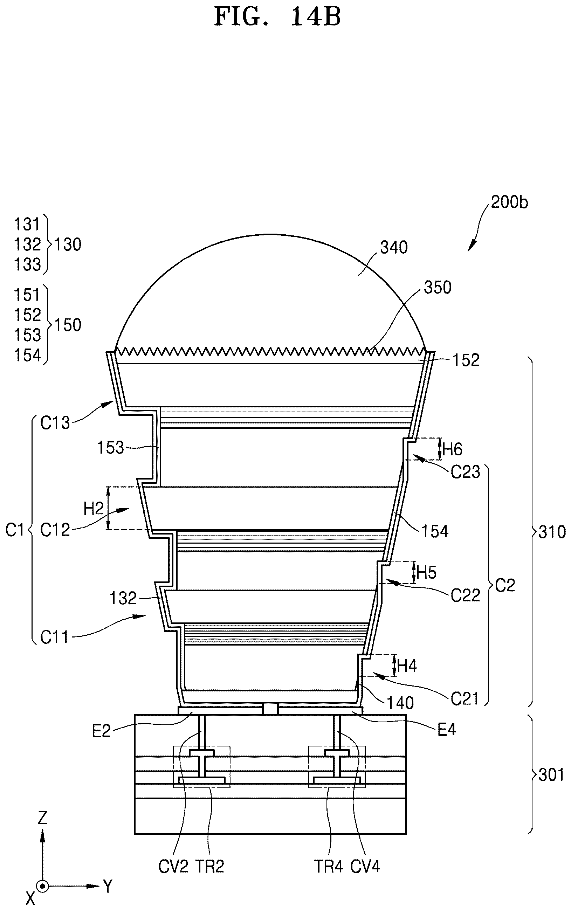

Referring to FIGS. 14A and 14B, a scattering pattern 350 may be formed on the second insulating layer 152, and an optical layer 340 may be formed on the scattering pattern 350. The optical layer 340 may adjust the propagation path of light generated in the light-emitting structure 110. Although FIGS. 14A and 14B illustrate a microlens as an optical element, embodiments are not limited thereto. For example, a fine structure such as a meta-structure may be provided as an optical element.

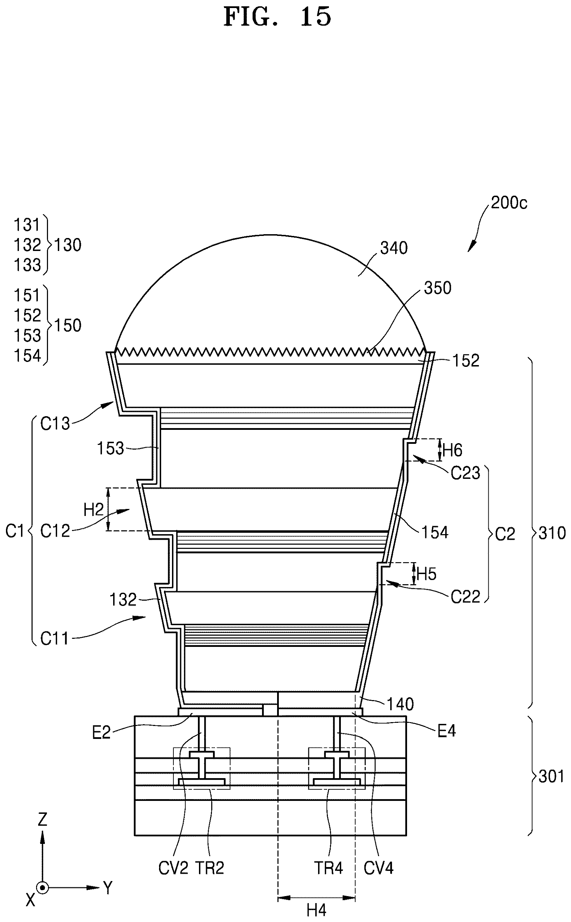

FIG. 15 is a view illustrating a display apparatus 200c according to one or more other embodiments. Comparing FIG. 15 with FIG. 3B, a second electrode pattern 140 may be in contact with a first-type semiconductor layer 11 of a first light-emitting element 10 at a lower surface of the first light-emitting element 10. The first-type semiconductor layer 11 of the first light-emitting element 10 is not partially etched, and thus, an etching process may be more simplified.

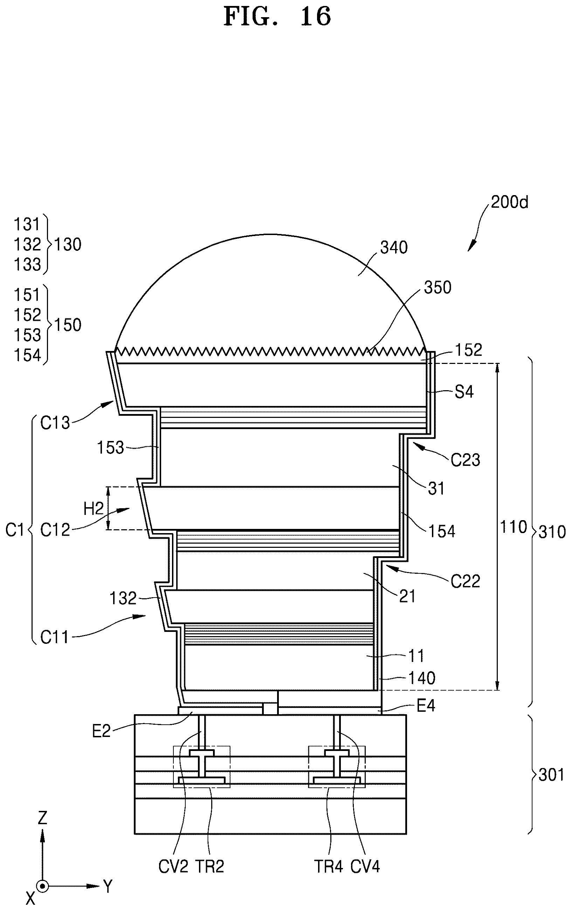

FIG. 16 is a view illustrating a display apparatus 200d according to one or more other embodiments. Comparing FIG. 16 with FIG. 15, a second outer surface S4 of a light-emitting structure 110 may be formed by a combination of horizontal and vertical surfaces relative to the thickness direction (Z direction) of a light-emitting structure 110. A second electrode pattern 140 may be in contact with lower surfaces S1 of first-type semiconductor layers 11, 21, and 31.

FIG. 17A is a cross-sectional view illustrating a display apparatus 200e from a first perspective, according to one or more other embodiments. FIG. 17B is a cross-sectional view illustrating the display apparatus 200e of FIG. 17A from another perspective, and FIG. 17C is a view illustrating a lower surface S1 of a light-emitting device 110 included in the display apparatus 200e shown in FIG. 17A. In FIGS. 17A, 17B, and 17C, components denoted with the same reference numbers as those in FIGS. 1A, 1B, and 1C have substantially the same structures and effects, and thus, repeated descriptions thereof are omitted.

Referring to FIGS. 17A, 17B, and 17C, a light-emitting structure 110 may be formed by sequentially stacked a third light-emitting element 30, a second light-emitting element 20, and a first light-emitting element 10 on a backplane 301. Each of the first to third light-emitting elements 10, 20, and 30 may be formed by sequentially stacking a second-type semiconductor layer 13, 23, or 33, an active layer 12, 22, or 32, and a first-type semiconductor layer 11, 21, or 31 above the backplane 301.

A third electrode 133 of a first electrode pattern 130 may be provided on the lower surface S1 of the light-emitting structure 110. The third electrode 133 may be in direct contact with the second-type semiconductor layer 33 of the third light-emitting element 30 at the lower surface S1 of the light-emitting structure 110. Here, a lower surface of the second-type semiconductor layer 33 of the third light-emitting element 30 may be the lower surface S1 of the light-emitting structure 110. A first electrode 131 and a second electrode 132 of the first electrode pattern 130 may be provided on a first outer surface S3 of the light-emitting structure 110 and extend to the lower surface S1. The first electrode 131 may be in contact with the second-type semiconductor layer 13 of the first light-emitting element 10 at the first outer surface S3 of the light-emitting structure 110, and the second electrode 132 may be in contact with the second-type semiconductor layer 23 of the second light-emitting element 20 at the first outer surface S3 of the light-emitting structure 110.

A second electrode pattern 140 may include a fourth electrode 141 and a fifth electrode 142 that are provided on a second outer surface S4 of the light-emitting structure 110 and extend to the lower surface S1. When the light-emitting structure 110 has a tetragonal cross-sectional shape in a direction perpendicular to the thickness direction (Z direction) of the light-emitting structure 110, because the third electrode 133 is provided on the lower surface S1 of the light-emitting structure 110, the second electrode pattern 140 may be formed on two lateral surfaces. Power efficiency may be increased by increasing the contact area between the second electrode pattern 140 and the first-type semiconductor layers 11, 21, and 31 of the light-emitting structure 110.

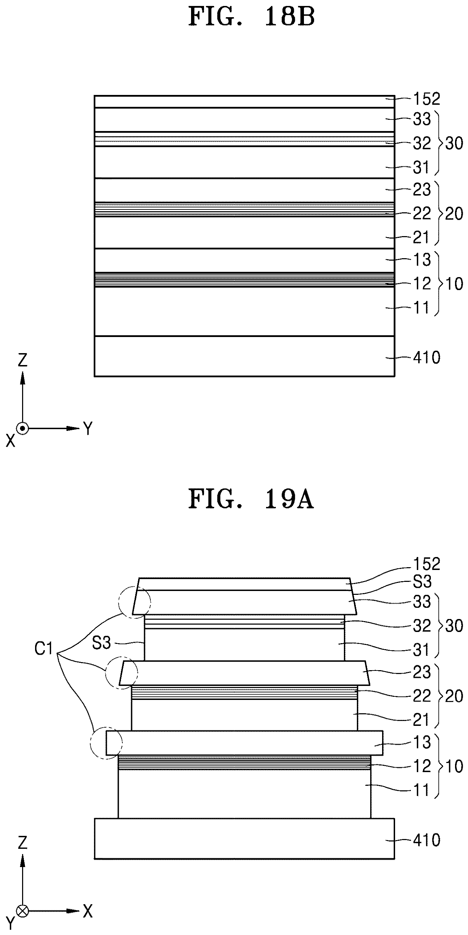

FIGS. 18A to 24B are cross-sectional views sequentially illustrating operations in a method of manufacturing the display apparatus 200e, according to embodiments. FIGS. 18A, 19A, 20A, 21A, 22A, 23A, and 24A are reference views illustrating the manufacturing method in relation to the cross-sectional view of the display apparatus 200e shown in FIG. 17A. FIGS. 18B, 19B, 20B, 21B, 22B, 23B, and 24B are reference views illustrating the manufacturing method in relation to the cross-sectional view of the display apparatus 200e shown in FIG. 17B.

Referring to FIGS. 18A and 18B, a light-emitting structure 110 may be formed on a growth substrate 410. The growth substrate 410 may be a layer for growing a light-emitting device.

A first light-emitting element 10, a second light-emitting element 20, and a third light-emitting element 30 may be sequentially and vertically formed on the growth substrate 410. For example, a first-type semiconductor layer 11, an active layer 12, and a second-type semiconductor layer 13 of the first light-emitting element 10 may be sequentially grown on the growth substrate 410. Then, a first-type semiconductor layer 21, an active layer 22, and a second-type semiconductor layer 23 of the second light-emitting element 20 may be sequentially grown on the second-type semiconductor layer 13 of the first light-emitting element 10. Then, a first-type semiconductor layer 31, an active layer 32, and a second-type semiconductor layer 33 of the third light-emitting element 30 may be sequentially grown on the second-type semiconductor layer 23 of the second light-emitting element 20.

Among the first to third light-emitting elements 10, 20, and 30, the indium content in the active layer 12 of the first light-emitting element 10 is the lowest, and the indium content in the active layer 32 of the third light-emitting element 30 is the highest. For example, the indium content in the active layer 12 of the first light-emitting element 10 is less than the indium content of the active layer 22 of the second light-emitting element 20, and the indium content in the second light-emitting element 20 is less than the indium content in the active layer 32 of the light-emitting element 30. As the indium content decreases, the growth temperature of a nitride semiconductor increases. Therefore, an active layer requiring a relatively high growth temperature may first be grown, and an active layer requiring a relatively low growth temperature may later be grown. When an active layer with a relatively high indium content is grown first and an active layer with a relatively low indium content is grown later, the active layer with a relatively high indium content may deteriorate. According to one or more embodiments, the growth sequence of the light-emitting structure 110 may prevent the deterioration of the active layer 32 of the third light-emitting element 30, which has a relatively high indium content.

A second insulating layer 152 may be further formed on an upper surface of the light-emitting structure 110. The second insulating layer 152 may include SiO₂ or the like and may be formed through a CVD process.

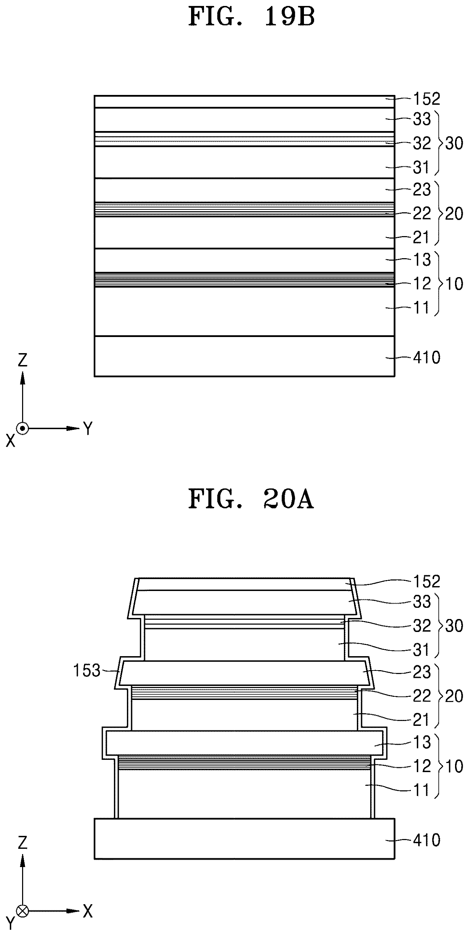

Referring to FIGS. 19A and 19B, a portion of an outer surface of the light-emitting structure 110 may be etched to form a first outer surface S3. The first outer surface S3 may include protrusions C1 at which the second-type semiconductor layers 13, 23, and 33 protrude outward. The first outer surface S3 may be formed by etching a portion of the outer surface of the light-emitting structure 110 at a certain angle relative to the thickness direction (Z direction) of the light-emitting structure 110. In addition, the protrusions C1 may be formed by selectively etching the first-type semiconductor layers 11, 21, and 31 and the active layers 12, 22, and 32 from the first outer surface S3 of the light-emitting structure 110.

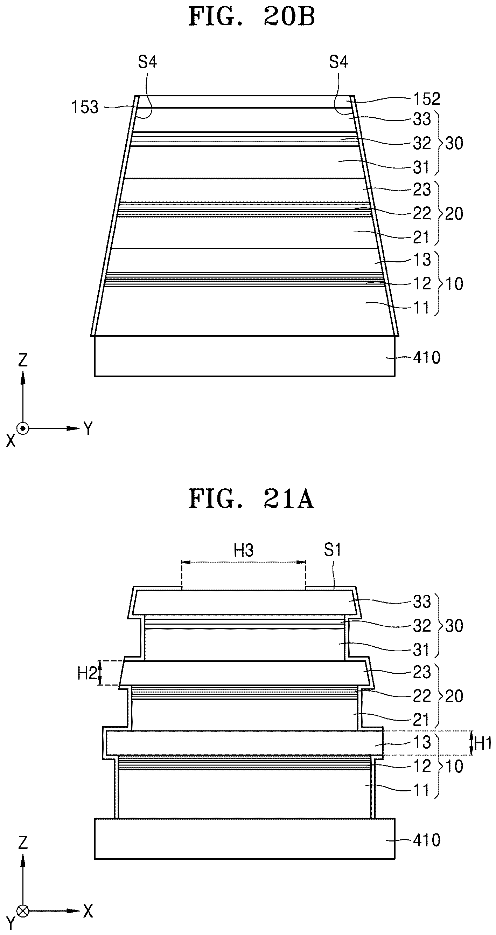

Referring to FIGS. 20A and 20B, a portion of the outer surface of the light-emitting structure 110 may be mesa etched to form a second outer surface S4. In addition, a third insulating layer 153 may be formed on the first and second outer surfaces S3 and S4 of the light-emitting structure 110. The remaining region of the outer surface of the light-emitting structure 110 may be mesa etched to form the second outer surface S4. The second outer surface S4 may be inclined at a certain angle relative to the thickness direction (Z direction) of the light-emitting structure 110. For example, the light-emitting structure 110 is etched such that the width of the light-emitting structure 110 in the horizontal direction (X direction and/or Y direction) may gradually decrease in the vertical direction (Z direction) from the first light-emitting element 10 toward the third light-emitting element 30. The third insulating layer 153 may be formed on the outer surface of the light-emitting structure 110, that is, on both the first outer surface S3 and the second outer surface S4 of the light-emitting structure 110.

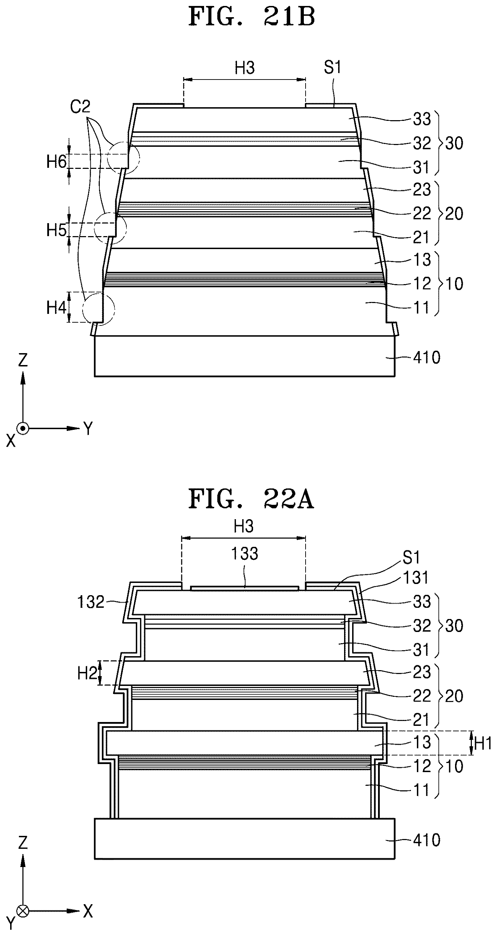

Referring to FIGS. 21A and 21B, a plurality of openings including first to sixth openings H1, H2, H3, H4, H5, and H6 may be formed in the second insulating layer 152 and the third insulating layer 153 to expose some regions of the light-emitting structure 110, and concave portions C2 may be formed in the second outer surface S4 of the light-emitting structure 110. For example, the second-type semiconductor layers 11 and 21 of the light-emitting structure 110 may be exposed by forming the first and second openings H1 and H2 in the third insulating layer 153 provided on the first outer surface S3 of the light-emitting structure 110. In addition, the second-type semiconductor layer 33 of the third light-emitting element 30 may be exposed by forming the third opening H3 in the third insulating layer 153 provided on an upper surface of the light-emitting structure 110. The first-type semiconductor layers 11, 21, and 31 of the light-emitting structure 110 may be exposed by forming the fourth to sixth openings H4, H5, and H6 in the third insulating layer 153 provided on the second outer surface S4 of the light-emitting structure 110. In addition, the concave portions C2 may be formed in the first-type semiconductor layers 11, 21, and 31 by further etching portions of the first-type semiconductor layers 11, 21, and 31.

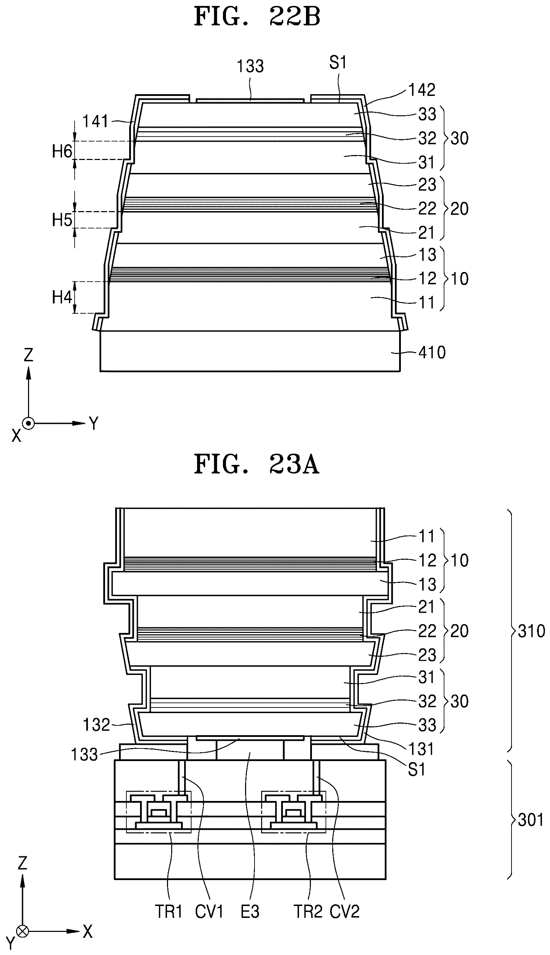

Referring to FIGS. 22A and 22B, a first electrode pattern 130 and a second electrode pattern 140 may be formed on the light-emitting structure 110. A first electrode 131, which is in contact with the second-type semiconductor layer 13 of the first light-emitting element 10 through the first opening H1, and a second electrode 132, which is in contact with the second-type semiconductor layer 23 of the second light-emitting element 20 through the second opening H2, may be formed on the third insulating layer 153 and the second insulating layer 152. In addition, a third electrode 133, which is in contact with the second-type semiconductor layer 33 of the third light-emitting element 30 through the third opening H3 may be formed.

A second electrode pattern 140, which is in contact with the first-type semiconductor layers 11, 21, and 31 of the light-emitting structure 110 through the fourth opening H4, the fifth opening H5, and the sixth opening H6, may be formed on the second insulating layer 152 and the third insulating layer 153

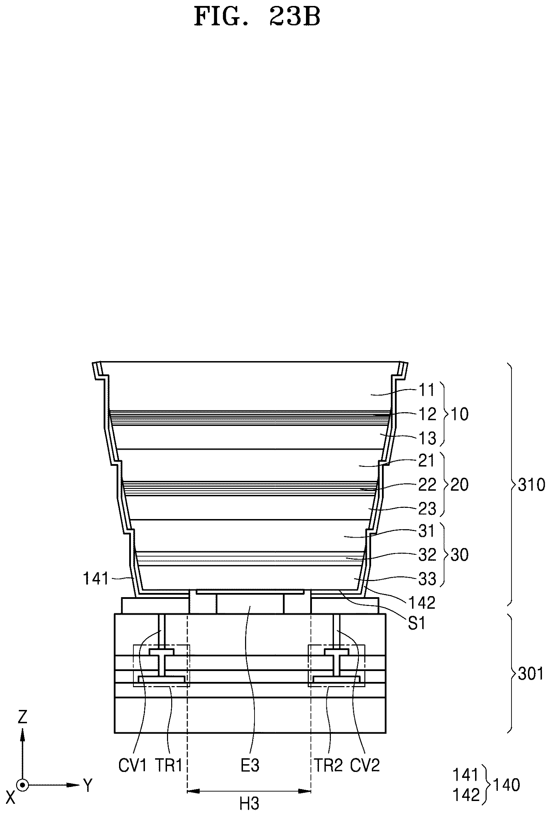

Referring to FIGS. 23A and 23B, the first electrode pattern 130 and the second electrode pattern 140 may be bonded to a backplane 301.

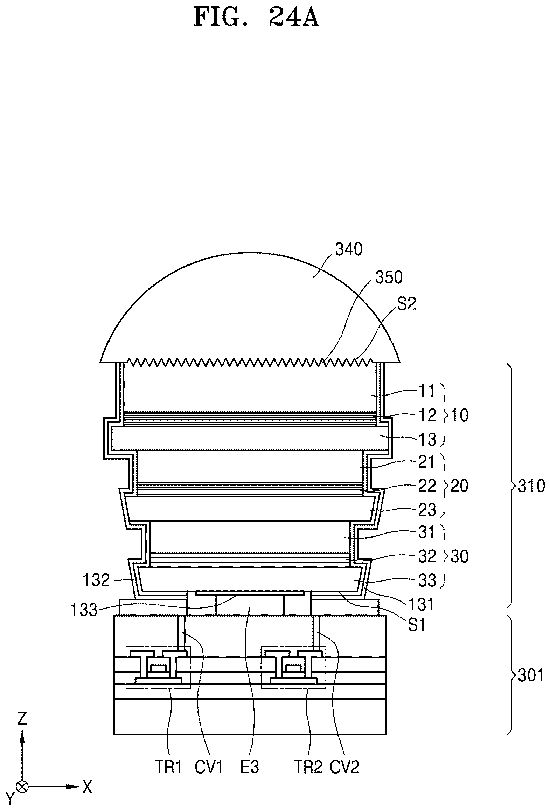

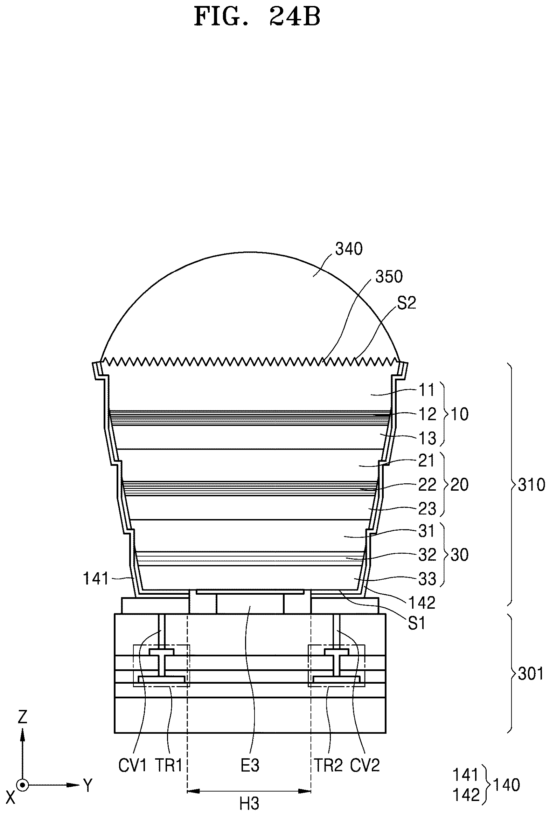

Referring to FIGS. 24A and 24B, a scattering pattern 350 may be formed on the first-type semiconductor layer 11 of the first light-emitting element 10, and an optical layer 340 may be formed on the scattering pattern 350. The optical layer 340 may adjust the propagation path of light generated in the light-emitting structure 110. Although FIGS. 24A and 24B illustrate a microlens as an optical element, embodiments are not limited thereto. For example, a fine structure such as a meta-structure may be formed as an optical element.

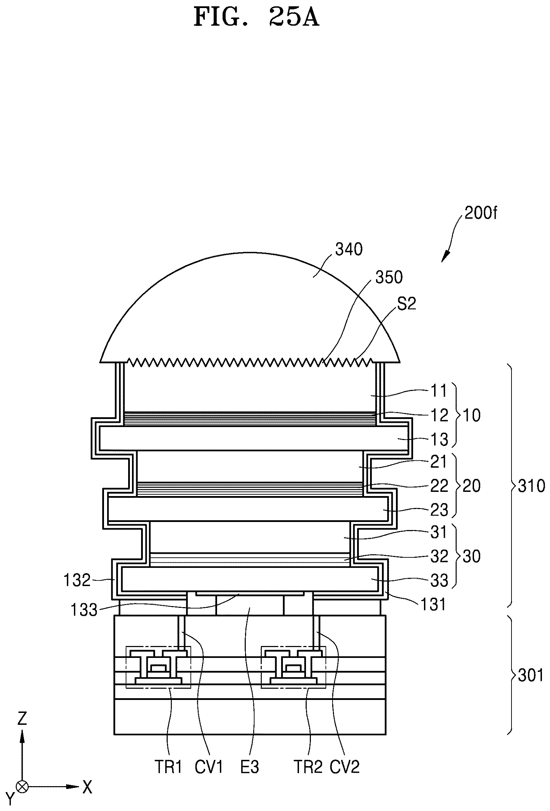

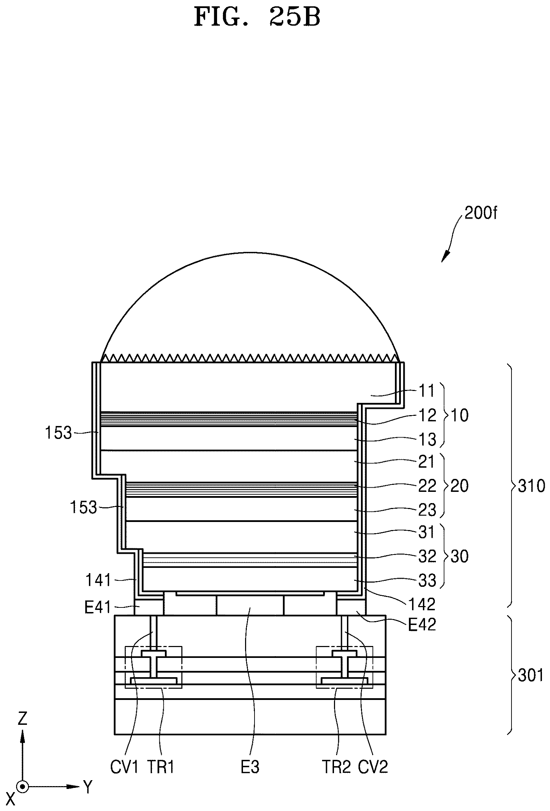

FIGS. 25A and 25B are views illustrating a display apparatus 200f according to one or more other embodiments. Comparing FIGS. 25A and 25B with FIGS. 17A and 17B, a second outer surface S4 of a light-emitting structure 110 may be formed by a combination of horizontal and vertical surfaces relative to the thickness direction (Z direction) of the light-emitting structure 110. A second electrode pattern 140 may be in contact with a lower surface of each of first-type semiconductor layers 11, 21, and 31.

In each of the display apparatuses 200, 200a, 200b, 200c, 200d, 200e, and 200f described above, a pixel capable of providing blue light, green light, and red light by using only one light-emitting device 100 may be implemented. Therefore, the display apparatuses 200, 200a, 200b, 200c, 200d, 200e, and 200f may provide ultra-high-resolution images and may have a relatively small size. The display apparatuses 200, 200a, 200b, 200c, 200d, 200e, and 200f may be applied to various electronic apparatuses having a display function.

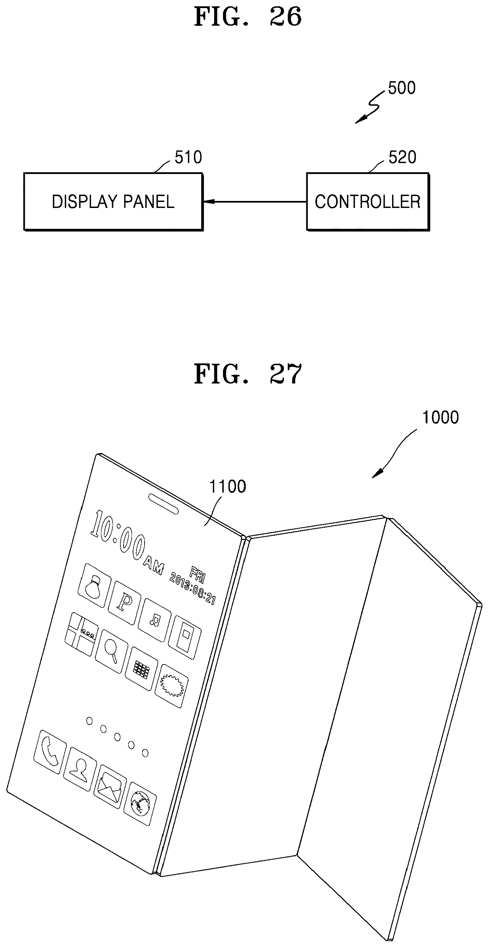

FIG. 26 is a view schematically illustrating an electronic apparatus 500 including a display apparatus. Referring to FIG. 26, the electronic apparatus 500 may include a display panel 510 and a controller (e.g., at least one processor) 520. The display panel 510 may incorporate any of the display apparatuses 200, 200a, 200b, 200c, 200d, 200e, and 200f described above. The controller 520 may control the display panel 510 based on an image signal.

FIG. 27 illustrates an example in which a display apparatus 1100 is applied to a mobile apparatus 1000 according to one or more embodiments. The mobile apparatus 1000 may include the display apparatus 1100. The display apparatus 1100 may include any of the display apparatuses 200, 200a, 200b, 200c, 200d, 200e, and 200f of the embodiments. The display apparatus 1100 may have a foldable structure, and may be implemented as, for example, a multi-folder display. Although FIG. 27 illustrates that the mobile apparatus 1000 includes a folder-type display, the mobile apparatus 1000 may include a flat-panel type display.

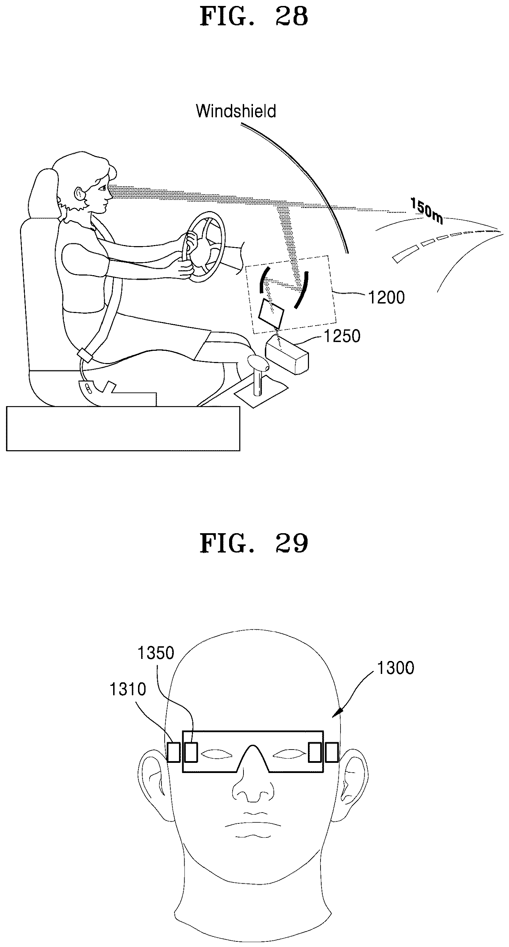

FIG. 28 illustrates an example in which a display apparatus is applied to a vehicle according to one or more embodiments. The display apparatus may be implemented as a vehicular head-up display apparatus. The vehicular head-up display apparatus may include a display apparatus 1250 that is provided in a region of the vehicle, and at least one optical path changing member 1200 that changes a path of light for a driver to view images generated by the display apparatus 1250. The display apparatus 1250 may include any of the display apparatuses 200, 200a, 200b, 200c, 200d, 200e, and 200f of the embodiments.

FIG. 29 illustrates an example in which a display apparatus is applied to augmented reality glasses 1300 or virtual reality glasses 1300. The augmented reality glasses 1300 may include a projection system 1310 configured to form an image, and at least one element 1350 configured to guide an image from the projection system 1310 to the user's eye. The projection system 1310 may include any of the display apparatuses 200, 200a, 200b, 200c, 200d, 200e, and 200f of the embodiments.

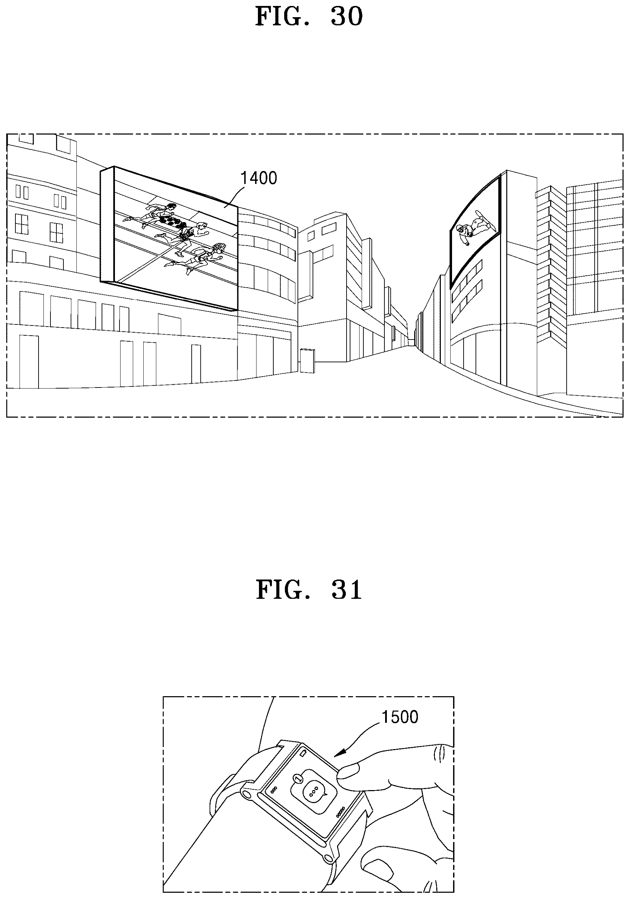

FIG. 30 illustrates an example in which a display apparatus is applied to large signage 1400 according to one or more embodiments. The signage 1400 may be used for outdoor advertising using a digital information display, and may control advertising content or the like through a communication network. The signage 1400 may be implemented by adopting, for example, any of the display apparatuses 200, 200a, 200b, 200c, 200d, 200e, and 200f of the embodiments.

FIG. 31 illustrates an example in which a display apparatus is applied to a display 1500 of a wearable apparatus according to one or more embodiments. The display 1500 of the wearable apparatus may be implemented by adopting any of the display apparatuses 200, 200a, 200b, 200c, 200d, 200e, and 200f of the embodiments.

The display apparatuses 200, 200a, 200b, 200c, 200d, 200e, and 200f of the embodiments may be applied to various products such as rollable televisions (TVs) or stretchable displays.

According to one or more embodiments, a light-emitting device may emit light of different wavelengths.

According to one or more embodiments, a light-emitting device is formed by vertically stacking a plurality of light-emitting elements and may thus have a relatively large active area for relatively high light emission efficiency.

According to one or more embodiments, an electrode pattern may be provided on a lateral surface of a light-emitting device without a conductive via structure, and thus, the light-emitting device may have a relatively large area for high light emission efficiency.

The light-emitting devices of the embodiments may be used to implement a display apparatus having improved light emission efficiency.

It should be understood that embodiments described herein should be considered in a descriptive sense only and not for purposes of limitation. Descriptions of features or aspects within each embodiment should typically be considered as available for other similar features or aspects in other embodiments. While embodiments have been described with reference to the figures, it will be understood by those of ordinary skill in the art that various changes in form and details may be made therein without departing from the scope as defined by the following claims and their equivalents.

## Claims

1. A display apparatus comprising:
a display layer comprising a plurality of light-emitting devices; and
a driving layer configured to drive the plurality of light-emitting devices,
wherein at least one of the plurality of light-emitting devices comprises:
a light-emitting structure comprising a first light-emitting element, a second light-emitting element, and a third light-emitting element being coupled to the driving layer, the first light-emitting element, the second light-emitting element, and the third light-emitting element being configured to emit light of different wavelengths and each of the first light-emitting element, the second light-emitting element, and the third light-emitting element comprising a first-type semiconductor layer, an active layer, and a second-type semiconductor layer;
a first electrode pattern being provided on a first outer surface of the light-emitting structure and a lower surface of the light-emitting structure, the first electrode pattern being configured to apply independent voltages respectively to the second-type semiconductor layers of the light-emitting structure;
a second electrode pattern being provided on a second outer surface of the light-emitting structure and the lower surface of the light-emitting structure, the second electrode pattern being configured to apply a common voltage to the first-type semiconductor layers of the light-emitting structure; and
an insulating layer being provided between the first electrode pattern and the light-emitting structure and between the second electrode pattern and the light-emitting structure, the insulating layer comprising a plurality of openings, the first electrode pattern and the second electrode pattern being connected to the light-emitting structure through the plurality of openings,
wherein the first outer surface comprises convex portions at which the second-type semiconductor layers of the light-emitting structure protrude from the first-type semiconductor layers and the active layers that are respectively adjacent to the second-type semiconductor layers.

2. The display apparatus of claim 1, wherein the first-type semiconductor layers are n-type semiconductor layers, and the second-type semiconductor layers are p-type semiconductor layers.

3. The display apparatus of claim 1 or 2, wherein the first electrode pattern comprises:
a first electrode connected to the second-type semiconductor layer of the first light-emitting element through a first opening of the insulating layer;
a second electrode connected to the second-type semiconductor layer of the second light-emitting element through a second opening of the insulating layer; and
a third electrode connected to the second-type semiconductor layer of the third light-emitting element through a third opening of the insulating layer,
wherein the first electrode, the second electrode, and the third electrode are spaced apart from each other.

4. The display apparatus of claim 3, wherein at least one of the first opening, the second opening, and the third opening is on the convex portions.

5. The display apparatus of any one of the foregoing claims, wherein the second outer surface comprises a concave portion at which at least one of the first-type semiconductor layers of the light-emitting structure is recessed into the light-emitting structure.

6. The display apparatus of claim 5, wherein the second electrode pattern contacts at least one of the first-type semiconductor layers of the light-emitting structure at the concave portion.

7. The display apparatus of claim 6, wherein the second electrode pattern contacts an outer surface of at least one of the first-type semiconductor layers at the concave portion.

8. The display apparatus of claim 6 or 7, wherein the second electrode pattern contacts a lower surface of at least one of the first-type semiconductor layers at the concave portion.

9. The display apparatus of claim 6, 7 or 8, wherein the second electrode pattern contacts the first-type semiconductor layer of the first light-emitting element through a fourth opening of the insulating layer, the first-type semiconductor layer of the second light-emitting element through a fifth opening of the insulating layer, and the first-type semiconductor layer of the third light-emitting element through a sixth opening of the insulating layer.

10. The display apparatus of claim 9, wherein at least one of the fourth opening, the fifth opening, and the sixth opening is on the concave portion, or wherein the fourth opening is on a lower surface of the first-type semiconductor layer of the first light-emitting element.

11. The display apparatus of any one of the foregoing claims, wherein, in each of the first light-emitting element, the second light-emitting element, and the third light-emitting element, the first-type semiconductor layer, the active layer, and the second-type semiconductor layer are stacked sequentially from the driving layer.

12. The display apparatus of any one of the foregoing claims, wherein a width of the light-emitting structure in a horizontal direction gradually increases in a vertical direction from the first light-emitting element toward the third light-emitting element, and/or
wherein a first wavelength of light emitted by the first light-emitting element is less than a second wavelength of light emitted by the second light-emitting element, and the second wavelength of light is less than a third wavelength of light emitted by the third light-emitting element, and/or
wherein a width of each of the second-type semiconductor layers of the light-emitting structure in a horizontal direction gradually increases in a vertical direction away from the driving layer.

13. The display apparatus of any one of the foregoing claims, further comprising an optical layer on the display layer and configured to control a propagation path of light emitted from the display layer, wherein preferably the optical layer comprises a plurality of microlenses corresponding one-to-one to the plurality of light-emitting devices.

14. The display apparatus of any one of the foregoing claims, wherein the display layer further comprises a scattering pattern that is configured to scatter light emitted from the display layer.

15. A method of manufacturing a display apparatus, the method comprising:
forming a light-emitting structure by sequentially monolithically stacking a first light-emitting element, a second light-emitting element, and a third light-emitting element on a growth substrate, the first light-emitting element, the second light-emitting element, and the third light-emitting element being configured to emit light of different wavelengths and each of the first light-emitting element, the second light-emitting element, and the third light-emitting element comprising a first-type semiconductor layer, an active layer, and a second-type semiconductor layer;
forming protrusions on a first outer surface of the light-emitting structure, the second-type semiconductor layers of the light-emitting structure protruding outward at the protrusions from the first-type semiconductor layers and the active layers that are respectively adjacent to the second-type semiconductor layers;
forming concave portions on a second outer surface of the light-emitting structure and recessed respectively into the first-type semiconductor layers of the light-emitting structure;
forming a first electrode pattern and a second electrode pattern, the first electrode pattern being in contact with the second-type semiconductor layers through the protrusions, the second electrode pattern contacting the first-type semiconductor layers through the concave portions; and
bonding the first electrode pattern and the second electrode pattern to a backplane.
